(19) Europäisches Patentamt
European Patent Office
Office européen des brevets

(11) EP 3 508 917 B1

(12) **EUROPEAN PATENT SPECIFICATION**

(45) Date of publication and mention of the grant of the patent:
**21.04.2021 Bulletin 2021/16**

(21) Application number: **17846260.2**

(22) Date of filing: **23.08.2017**

(51) Int Cl.:
***G03F 7/038*** (2006.01) ***G03F 7/039*** (2006.01)

(86) International application number:
**PCT/JP2017/030178**

(87) International publication number:
**WO 2018/043255 (08.03.2018 Gazette 2018/10)**

(54) **ACTIVE RAY-SENSITIVE OR RADIATION-SENSITIVE RESIN COMPOSITION, PATTERN FORMATION METHOD, AND ELECTRONIC DEVICE PRODUCTION METHOD**

AKTIVSTRAHLENEMPFINDLICHE ODER STRAHLUNGSEMPFINDLICHE HARZZUSAMMENSETZUNG, STRUKTURBILDUNGSVERFAHREN UND HERSTELLUNGSVERFAHREN FÜR ELEKTRONISCHE VORRICHTUNG

COMPOSITION DE RÉSINE SENSIBLE AUX RAYONS ACTIFS OU SENSIBLE AUX RAYONNEMENTS, PROCÉDÉ DE FORMATION DE MOTIF ET PROCÉDÉ DE PRODUCTION DE DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2016 JP 2016169385**

(43) Date of publication of application:
**10.07.2019 Bulletin 2019/28**

(73) Proprietor: **FUJIFILM Corporation**
**Tokyo 106-8620 (JP)**

(72) Inventors:
- **NIHASHI, Wataru**
  **Haibara-gun**
  **Shizuoka 421-0396 (JP)**
- **FURUTANI, Hajime**
  **Haibara-gun**
  **Shizuoka 421-0396 (JP)**
- **KANEKO, Akihiro**
  **Haibara-gun**
  **Shizuoka 421-0396 (JP)**
- **TSUBAKI, Hideaki**
  **Haibara-gun**
  **Shizuoka 421-0396 (JP)**
- **HIRANO, Shuji**
  **Haibara-gun**
  **Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:

| | |
|---|---|
| EP-A1- 0 996 870 | WO-A1-2017/029891 |
| WO-A1-2017/115629 | CN-A- 101 974 121 |
| JP-A- 2009 086 354 | JP-A- 2012 219 162 |
| JP-A- 2014 041 326 | JP-A- 2014 059 543 |
| JP-A- 2015 197 482 | US-A1- 2015 147 699 |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 508 917 B1

Printed by Jouve, 75001 PARIS (FR)

## Description

## BACKGROUND OF THE INVENTION

1. Field of the Invention

The present invention relates to an actinic ray-sensitive or radiation-sensitive resin composition, a pattern forming method, and a method of manufacturing an electronic device.

More specifically, the present invention relates to an actinic ray-sensitive or radiation-sensitive resin composition used in a step of manufacturing a semiconductor such as an IC, the manufacturing of a circuit substrate such as a liquid crystal and a thermal head, and a lithographic step of other photofabrication, a pattern forming method, and a method of manufacturing an electronic device including the pattern forming method.

2. Description of the Related Art

In the related art, microfabrication by lithography using a resist composition has been performed in the process of manufacturing a semiconductor device such as an integrated circuit (IC) and a large scale integrated circuit (LSI). In recent years, according to the high integration of integrated circuits, formation of ultrafine patterns in a submicrometer (submicron) submicron region and a quarter micrometer (micron) region has been required. Along with this, there is a tendency in that an exposure wavelength also becomes shorter from g rays to i rays further to excimer laser light such as KrF (for example, see JP1996-337616A (JP-H08-337616A) and JP2000-267280A). These days, lithography using electron beams, X-rays, or extreme ultraviolet rays (EUV light) in addition to the excimer laser light is also being developed (for example, see JP2005-275282A).

The high functionality of various electronic apparatuses are required, and accordingly, further improvement in characteristics of the resist pattern used for microfabrication is also required, but it was difficult to simultaneously satisfy resolution, roughness characteristics such as line width roughness (LWR), and exposure latitude (EL) to a recently required level.

In particular, in the case of exposing the resist film to EUV light, since the exposure is usually performed under vacuum, there is tendency in that gas derived from the reactant or the like in an exposed portion is easily generated from the resist film, but there is concern in that the gas may damage the exposure machine.

US 2015/147699 A1 describes a pattern forming method that includes (i) forming a film using an actinic ray-sensitive or radiation-sensitive resin composition which contains a resin (A) which has a repeating unit including a group capable of generating a polar group by being decomposed due to an action of an acid and a repeating unit including a carboxyl group, a compound (B) which generates an acid according to irradiation with actinic rays or radiation, and a solvent (C); (ii) exposing the film using a KrF excimer laser, extreme ultraviolet rays, or an electron beam; and (iii) forming a negative tonetone pattern by developing the exposed film using a developer which includes an organic solvent.

JP 2009 086354 A describes a chemical amplification-type positive resist composition that includes: a resin containing a repeating unit having a group expressed by $-CH_2-Y-Z^1$, wherein Y represents a single bond or a bivalent linking group and $Z^1$ represents an optional substituent, and a specific acid decomposable repeating unit on a benzene ring, of which solubility in an alkali developer increases under an action of an acid; and a compound capable of generating an acid upon irradiation with actinic rays or radiation. Also described is a pattern forming method that uses the positive resist composition

JP 2015 197482 A describes a manufacturing method of an active light-sensitive or radiation-sensitive resin composition containing a resin, an acid generator, an organic acid and a solvent, which includes any process selected from following steps (i), (ii) and (iii), wherein, in the method of manufacturing the active light-sensitive or radiation-sensitive resin composition, a percentage content of the organic acid in the active light-sensitive or radiation-sensitive resin composition is more than 5 mass% in terms of all solid content in the composition. (i) a process of dissolving the organic acid in a solution having substantially no resin and acid generator, (ii) a process of dissolving the organic acid in a solution containing the acid generator and substantially no resin, and (iii) a process of dissolving the organic acid in a solution containing the resin and substantially no acid generator.

EP 0 996 870 A1 describes dissolution inhibition resists for use in microlithography that are comprised of phenolic base resin(s) having increased inhibitability and which are suitable for use in resist formulations for microlithography and semidonductor applications.

JP 2012 219162 A describes a method for producing a resin for resist compositions having structural units represented by formulas (I) and (II), wherein the method includes the first step of polymerizing a monomer represented by formula (III) and a monomer represented by formula (IV), and the second step of hydrolyzing the product obtained in the first step to convert -O-CO-R into -OH; wherein, $R^1$ and $R^5$ are each alkyl which may have a halogen atom, hydrogen atom or halogen atom; $R^2$-$R^4$ are each alkyl or an alicyclic hydrocarbon group; $R^2$ and $R^3$ are bound to each

other to form a divalent hydrocarbon group; $X^1$ and $X^2$ are each a single bond or a divalent linking group.

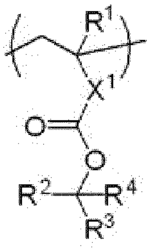
(I)

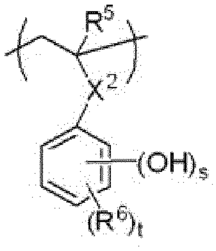
(II)

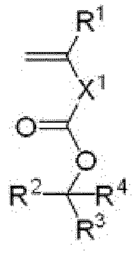
(III)

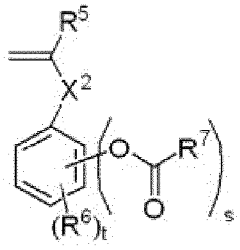
(IV)

JP 2014 041326 A describes an actinic ray-sensitive or radiation-sensitive resin composition that comprises a resin (P) having a repeating unit (a) expressed by general formula (1). In general formula (1), $R_{11}$, $R_{12}$ and $R_{13}$ each independently represent a hydrogen atom, an alkyl group, a cycloalkyl group, a halogen atom, a cyano group or an alkoxycarbonyl group.

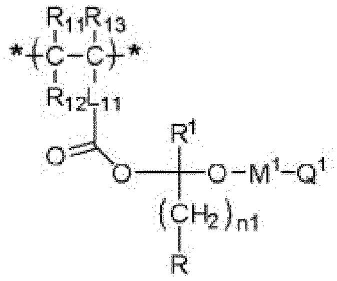
(1)

CN 101 974 121 A describes a chemical amplification-type positive resist composition and a pattern forming method using the composition. The positive resist composition includes: a resin containing a repeating unit having a group expressed by $-CH_2-Y-Z^1$, wherein Y represents a single bond or a bivalent linking group and $Z^1$ represents an optional substituent, and a specific acid decomposable repeating unit on a benzene ring, of which solubility in an alkali developer increases under an action of an acid; and a compound capable of generating an acid upon irradiation with actinic rays or radiation.

**SUMMARY OF THE INVENTION**

In view of the above, an object of the present invention is to provide an actinic ray-sensitive or radiation-sensitive resin composition that can form a pattern excellent in resolution, roughness characteristics, exposure latitude, and outgassing performance at a high level and a pattern forming method. Another object of the present invention is to provide a method of manufacturing an electronic device including the pattern forming method.

The present inventors have diligently researched the above objects to find that the above objects can be achieved by using a resin (hereinafter, referred to as a "resin (A)") including a specific repeating unit (a) having two or more phenolic hydroxyl groups and a repeating unit (b) having an acid-decomposable group protected by a protective group having a specific structure, as a base resin of the actinic ray-sensitive or radiation-sensitive resin composition. The present invention relates to an actinic ray-sensitive or radiation-sensitive resin composition comprising:

a resin including a repeating unit (a) represented by Formula (1-1) and a repeating unit (b) having a group in which a protective group including an aliphatic monocyclic ring leaves due to an action of an acid to generate a polar group; and

a compound that generates an acid due to irradiation with an actinic ray or radiation,

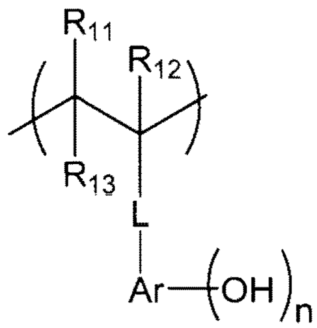

(I-1)

in the formula,

$R_{11}$ and $R_{12}$ each independently represent a hydrogen atom or an alkyl group,
$R_{13}$ represents a hydrogen atom or an alkyl group, or is a single bond or an alkylene group, and is bonded to L or Ar in the formula to form a ring,
L represents a single bond or a divalent linking group,
Ar represents an aromatic ring, and
n represents an integer of 2 or more.

An embodiment thereof is an actinic ray-sensitive or radiation-sensitive resin composition as claimed in claim 2, in which, in the repeating unit (b), the polar group generated by leaving of the protective group is a carboxyl group.

A further embodiment thereof is an actinic ray-sensitive or radiation-sensitive resin composition as claimed in claim 3, in which, in the repeating unit (b), the aliphatic monocyclic ring included in the protective group is a monocyclic hydrocarbon group.

A further embodiment thereof is an actinic ray-sensitive or radiation-sensitive resin composition as claimed in claim 4, in which, in Formula (I-1), Ar is a benzene ring, and n is an integer of 2 to 5.

A further embodiment thereof is an actinic ray-sensitive or radiation-sensitive resin composition as claimed in claim 5, in which, in Formula (I-1), n is 2 or 3.

A further embodiment thereof is an actinic ray-sensitive or radiation-sensitive resin composition as claimed in claim 6, which, in Formula (1-1), L is a single bond or an ester bond.

A further embodiment thereof is an actinic ray-sensitive or radiation-sensitive resin as claimed in claim 7, in which a content of the repeating unit (a) represented by Formula (I-1) is 5 to 60 mol% with respect to all repeating units in the resin.

A further embodiment thereof is an actinic ray-sensitive or radiation-sensitive resin composition as claimed in claim 8, in which the repeating unit (b) is represented by Formula (pA),

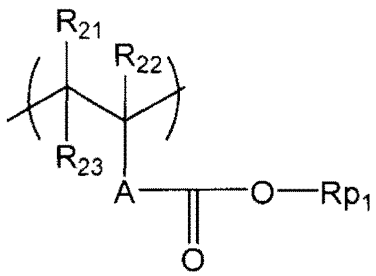

(pA)

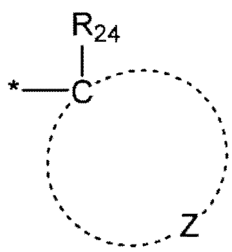

(pI)

in Formula (pA),

$R_{21}$, $R_{22}$, and $R_{23}$ each independently represent a hydrogen atom or an alkyl group,
A represents a single bond or a divalent linking group, and
$Rp_1$ represents a group represented by Formula (pI), and
in Formula (pI),
$R_{24}$ represents a methyl group, an ethyl group, an n-propyl group, an isopropyl group, an n-butyl group, an isobutyl group, a sec-butyl group, or a tert-butyl group,

Z represents an atomic group required for forming a monocyclic cycloalkyl group together with a carbon atom in the formula, and
* represents a linking portion to a remainder of a repeating unit represented by Formula (pA).

A further embodiment thereof is an actinic ray-sensitive or radiation-sensitive resin composition as claimed in claim 9, in which, in Formula (pA), A is a single bond.

A further embodiment thereof is an actinic ray-sensitive or radiation-sensitive resin composition as claimed in claim 10, in which, in Formula (pA), the number of carbon atoms of the cycloalkyl group formed by Z together with carbon atoms in the formula is 5 to 10.

The present invention further relates to a pattern forming method, comprising:

forming an actinic ray-sensitive or radiation-sensitive film including the actinic ray-sensitive or radiation-sensitive resin composition according to any one of claims 1-10,
exposing the actinic ray-sensitive or radiation-sensitive film; and
developing the exposed actinic ray-sensitive or radiation-sensitive film with a developer.

An embodiment thereof is claimed in claim 12.

The present invention also relates to a method of manufacturing an electronic device comprising: the pattern forming method according to claim 11 or claim 12.

According to the present invention, it is possible to provide an actinic ray-sensitive or radiation-sensitive resin composition that can form a pattern excellent in resolution, roughness characteristics, exposure latitude, and outgassing performance at a high level and a pattern forming method. In addition, according to the present invention, it is possible to provide a method of manufacturing an electronic device including the pattern forming method.

## DESCRIPTION OF THE PREFERRED EMBODIMENTS

Hereinafter, an example of an aspect for implementing the present invention is described.

With respect to an expression of a group and an atomic group in the present specification, in a case where substitution or non-substitution is not indicated, both of a group not having a substituent and a group having a substituent are included. For example, an "alkyl group" that does not indicate substitution or non-substitution includes not only an alkyl group (unsubstituted alkyl group) not having a substituent but also an alkyl group (substituted alkyl group) having a substituent.

An "actinic ray" or a "radiation" in the present invention, for example, means a bright line spectrum of a mercury lamp, or a particle beam such as a far ultraviolet ray represented by an excimer laser, an extreme ultraviolet ray (EUV light), an X-ray, an electron beam, and an ion beam. In the present invention, the "light" means actinic rays or radiation.

Unless described otherwise, the "exposure" in the present specification includes not only exposure to a bright line spectrum of a mercury lamp, a far ultraviolet ray represented by an excimer laser, an X-ray, and an extreme ultraviolet ray (EUV light) represented by an excimer laser but also drawing by a particle ray such as an electron beam and an ion beam.

In the present specification, "(meth)acrylate" means "at least one of acrylate or methacrylate". "(Meth)acrylic acid" means "at least one of acrylic acid or methacrylic acid".

In the present specification, the numerical range expressed by using "to" means a range including numerical values described before and after "to" as a lower limit and an upper limit.

In the present specification, a weight-average molecular weight of a resin is a value in terms of polystyrene measured by a gel permeation chromatography (GPC) method. The GPC corresponds to a method in which HLC-8120 (manufactured by Tosoh Corporation) is used, TSK gel Multipore HXL-M (manufactured by Tosoh Corporation, 7.8 mm ID $\times$ 30.0 cm) is used as a column, and tetrahydrofuran (THF) is used as an eluent.

[Actinic ray-sensitive or radiation-sensitive resin composition]

The actinic ray-sensitive or radiation-sensitive resin composition according to the embodiment of the present invention is typically a resist composition and is preferably a chemically amplified resist composition.

The actinic ray-sensitive or radiation-sensitive resin composition is preferably an actinic ray-sensitive or radiation-sensitive resin composition for organic solvent development using a developer including an organic solvent and/or for alkali development using an alkali developer. Here, the organic solvent development means at least an application to be provided in a step of development using a developer including an organic solvent. The alkali development means at least an application to be provided in a step of development using an alkali developer.

The actinic ray-sensitive or radiation-sensitive resin composition may be a positive resist composition or may

be a negative resist composition.

The actinic rays or radiation applied to the actinic ray-sensitive or radiation-sensitive resin composition is not particularly limited, and for example, KrF excimer laser, ArF excimer laser, extreme ultraviolet rays (EUV), and electron beams (EB) or the like can be used, but an application for electron beam or extreme ultraviolet exposure is preferable.

Hereinafter, respective essential components and optional components contained in the actinic ray-sensitive or radiation-sensitive resin composition are described.

<Resin (A)>

The actinic ray-sensitive or radiation-sensitive resin composition according to the embodiment of the present invention includes the repeating unit (a) having two or more phenolic hydroxyl groups represented by Formula (1-1) and a repeating unit (b) having a group (hereinafter, referred to as an "acid-decomposable group") in which a protective group including an aliphatic monocyclic ring leaves due to an action of an acid so as to generate a polar group, as a base resin.

By combining the repeating unit (a) and the repeating unit (b), it is possible to cause the deprotection reactivity of the acid-decomposable group and the diffusion suppressing performance on an acid (hereinafter, referred to as a "generated acid") generated from a compound (B) described below to be compatible with each other at a high level. As a result, it is possible to cause roughness characteristics such as resolution, EL, and LWR to be compatible with each other at an extremely high level, and satisfactory outgassing performances can be provided.

By at least two phenolic hydroxyl groups included in the repeating unit (a), it is possible to suppress the diffusion of the generated acid by the increase of the reactivity due to hydrophilization of a film and the increase in the glass transition temperature (hereinafter referred to as "high Tg") due to an improvement in the hydrogen bonding force. It is assumed that, by selecting the repeating unit (b) having an acid-decomposable group protected with a protective group including an aliphatic monocyclic ring that can cause the deprotection reactivity in the acid-decomposable group and the diffusion suppressing performance of the generated acid to be compatible with each other, as a repeating unit having an acid-decomposable group combined with the repeating unit (a), it is possible to maximize the superiority of the repeating unit (a), such that a pattern that is excellent in all of resolution, EL, roughness characteristics, and outgassing performance at a high level can be formed.

-Repeating unit (a)-

The repeating unit (a) is a repeating unit having two or more phenolic hydroxyl groups represented by Formula (1-1).

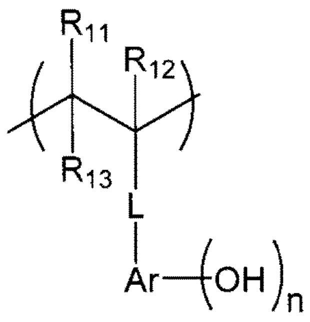

(I-1)

In the formula,

$R_{11}$ and $R_{12}$ each independently represent a hydrogen atom or an alkyl group.
$R_{13}$ represents a hydrogen atom or an alkyl group or is a single bond or an alkylene group, and is bonded to L or Ar in the formula to form a ring.
L represents a single bond or a divalent linking group.
Ar represents an aromatic ring.
n represents an integer of 2 or more.

Examples of the alkyl group represented by $R_{11}$, $R_{12}$, and $R_{13}$ in Formula (1-1) include an alkyl group having 20 or less carbon atoms such as a methyl group, an ethyl group, a propyl group, an isopropyl group, an n-butyl group,

a sec-butyl group, a hexyl group, a 2-ethylhexyl group, an octyl group, and a dodecyl group. In one aspect, the alkyl group represented by $R_{11}$, $R_{12}$, and $R_{13}$ is preferably an alkyl group having 8 or less carbon atoms and more preferably an alkyl group having 3 or less carbon atoms.

An alkyl group represented by $R_{11}$, $R_{12}$, and $R_{13}$ may have a substituent. Examples of the preferable substituent include a cycloalkyl group, an aryl group, an amino group, an amide group, a ureido group, a urethane group, a hydroxyl group, a carboxyl group, a halogen atom, an alkoxy group, a thioether group, an acyl group, an acyloxy group, an alkoxycarbonyl group, a cyano group, and a nitro group, and it is preferable that the number of carbon atoms of the substituent is 8 or less.

The divalent linking group represented by L includes, for example, an ester bond, -CONR$_{64}$ (R$_{64}$ represents a hydrogen atom or an alkyl group)-, an alkylene group, or a combination of two or more selected from any of these.

The alkyl group of $R_{64}$ in -CONR$_{64}$- (R$_{64}$ represents a hydrogen atom or an alkyl group) is preferably an alkyl group having 20 or less carbon atoms such as a methyl group, an ethyl group, a propyl group, an isopropyl group, an n-butyl group, a sec-butyl group, a hexyl group, a 2-ethylhexyl group, an octyl group, and a dodecyl group, which may have a substituent, and more preferably an alkyl group having 8 or less carbon atoms. In one aspect, -CONR$_{64}$- is preferably -CONH-.

Examples of the alkylene group represented by L include an alkylene group having 1 to 8 carbon atoms such as a methylene group, an ethylene group, a propylene group, a butylene group, a hexylene group, and an octylene group. The alkylene group may have a substituent.

In one aspect of the present invention, L is preferably a single bond, an ester bond, or -CONH-, more preferably a single bond or an ester bond, and particularly preferably a single bond.

Examples of the aromatic ring group represented by Ar include an aromatic hydrocarbon ring having 6 to 18 carbon atoms such as a benzene ring, a naphthalene ring, an anthracene ring, a fluorene ring, and a phenanthrene ring and an aromatic ring heterocyclic ring including a heterocyclic ring such as a thiophene ring, a furan ring, a pyrrole ring, a benzothiophene ring, a benzofuran ring, a benzopyrrole ring, a triazine ring, an imidazole ring, a benzimidazole ring, a triazole ring, a thiadiazole ring, or a thiazole ring. Among these, a benzene ring and a naphthalene ring are preferable in view of resolution, and a benzene ring is most preferable.

These aromatic rings may have a substituent. Examples of the preferable substituent include specific examples of the alkyl group represented by $R_{11}$, $R_{12}$, and $R_{13}$; an alkoxy group such as a methoxy group, an ethoxy group, a hydroxyethoxy group, a propoxy group, a hydroxypropoxy group, and a butoxy group; and an aryl group such as a phenyl group.

n represents an integer of 2 or more, preferably represents an integer of 2 to 5, and more preferably represents 2 or 3.

The resin (A) may contain two or more kinds of the repeating units (a).

Specific examples of the repeating unit (a) are provided below, but the present invention is not limited to these. In the formula, R represents a hydrogen atom or a methyl group, and a represents 2 or 3.

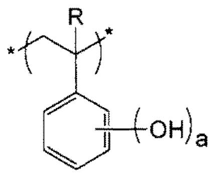
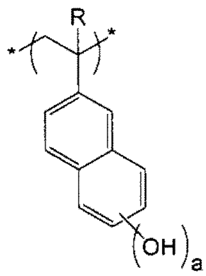
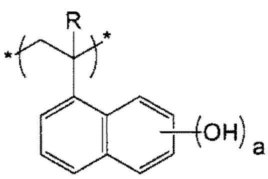

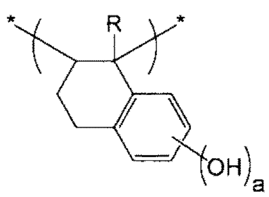
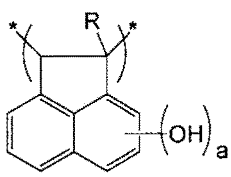

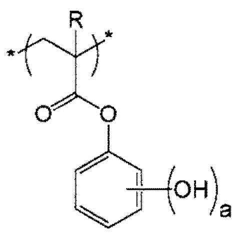
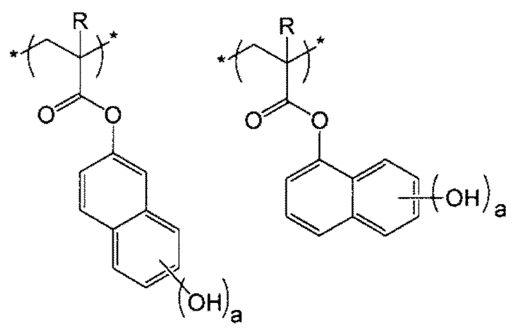

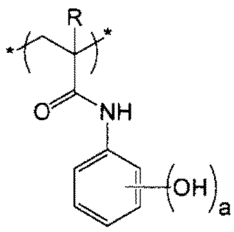
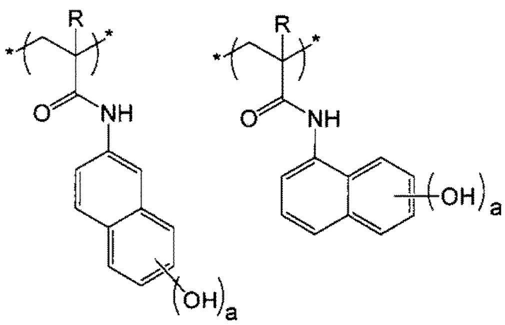

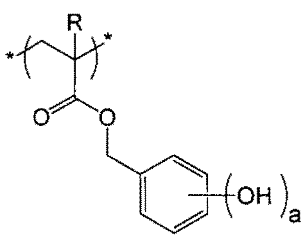
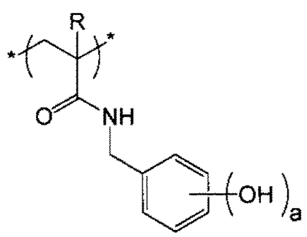

In view of compatibility between the reactivity of the resin (A) and the diffusion suppressing performance of generated acid, the content (total content ratio in a case where two or more kinds thereof are contained) of the repeating unit (a) is preferably 5 to 60 mol%, more preferably 10 to 50 mol%, and even more preferably 20 to 40 mol% with respect to all repeating units in the resin (A).

-Repeating unit (b)-

The repeating unit (b) is a repeating unit having an acid-decomposable group that a protective group including an aliphatic monocyclic ring leaves due to an action of an acid so as to generate a polar group.

Compared with a protective group including a polycyclic structure or a protective group including a chain-like

group, the protective group including an aliphatic monocyclic ring can cause the high deprotection reactivity in the acid-decomposable group and the low diffusion of the generated acid to be compatible with each other. The protective group having a polycyclic structure causes a problem that the number of carbon atoms increases to become hydrophobic and sensitivity is lowered, and the protective group including a chain-like group causes a problem that Tg is lowered and diffusion of generated acid is promoted. By having a protective group including an aliphatic monocyclic ring, in a case of being combined with the repeating unit (a) having two or more phenolic hydroxyl groups to be used, the superiority of the repeating unit (a) can be maximized, and a pattern excellent in resolution, EL, roughness characteristics and outgassing performance at a high level can be formed.

Here, a monocyclic ring included in a protective group included in the repeating unit (b) is an aliphatic ring and may include an unsaturated bond. In one aspect of the present invention, this monocyclic ring is preferably a monocyclic hydrocarbon group consisting solely of carbon atoms and hydrogen atoms.

In view of hydrophilicity, it is better that the number of carbon atoms forming a monocyclic ring is small. For example, the number of carbon atoms forming the monocyclic ring is preferably 5 to 10, more preferably 5 to 8, even more preferably 5 to 7.

The monocyclic ring may have a substituent, and the substituent may include an atom in addition to the carbon atom and the hydrogen atom. Examples of the substituent that may be included include an alkyl group (having 1 to 4 carbon atoms), a halogen atom, a hydroxyl group, an alkoxy group (having 1 to 4 carbon atoms), a carboxyl group, an alkoxycarbonyl group (having 2 to 6 carbon atoms), a cyano group, an amino group, a sulfonamide group, and an alkylamide group.

In the repeating unit (b), examples of the polar group generated by the leaving of the protective group including an aliphatic monocyclic hydrocarbon group due to an action of an acid include a carboxyl group, a benzene carboxylic acid group, a phenolic hydroxyl group, and a hydroxyl group. In one aspect of the present invention, it is preferable that the polar group is a carboxyl group.

Here, it is preferable that the polar group is a carboxyl group, in view of compatibility between high reactivity of the resin (A) and the diffusion suppressing performance of generated acid. For example, in a case where the polar group is a carboxyl group, particularly, Tg after the exposure is high and the diffusion suppression of an acid is excellent compared with a case where the polar group is a phenolic hydroxyl group or a hydroxyl group. Also in a case of being combined with a protective group, the acid strength of the polar group is higher, and thus deprotection reactivity is excellent.

According to the embodiment of the present invention, the repeating unit (b) is preferably a repeating unit represented by Formula (pA).

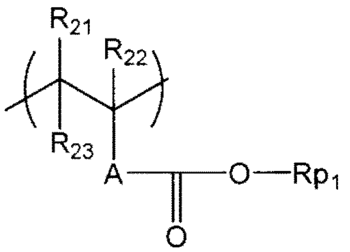

(pA)

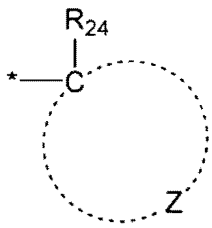

(pI)

In Formula (pA),

$R_{21}$, $R_{22}$, and $R_{23}$ each independently represent a hydrogen atom or an alkyl group.
A represents a single bond or a divalent linking group.
$Rp_1$ represents a group represented by Formula (pI).

In Formula (pI),
$R_{24}$ represents a methyl group, an ethyl group, an n-propyl group, an isopropyl group, an n-butyl group, an isobutyl group, a sec-butyl group, or a tert-butyl group. According to an aspect, $R_{24}$ is preferably a methyl group.
Z represents an atomic group required for forming a monocyclic cycloalkyl group together with a carbon atom in the formula.
* represents a linking portion to a remainder of a repeating unit represented by Formula (pA).

Specific examples of the alkyl group represented by $R_{21}$, $R_{22}$, and $R_{23}$ in Formula (pA) include the same specific examples exemplified in the alkyl group represented by $R_{11}$, $R_{12}$ and $R_{13}$ in Formula (1-1), and preferable specific examples thereof are also the same.

An alkyl group represented by $R_{21}$, $R_{22}$, and $R_{23}$ may have a substituent. Specific examples of the preferable substituent include the same specific examples exemplified in the substituent that may be included in the alkyl group represented by $R_{11}$, $R_{12}$, and $R_{13}$ in Formula (I-1)

Examples of the divalent linking group represented by A include an arylene group and a -COO-Rt- group. In the formula, Rt represents an alkylene group or a cycloalkylene group.

In one aspect of the present invention, A is preferably a single bond.

As described above, Z represents an atomic group required for forming a cycloalkyl group together with a carbon atom in the formula. In view of hydrophilicity, the number of carbon atoms of the cycloalkyl group formed by Z together with carbon atoms in the formula is preferably 5 to 10, more preferably 5 to 8, and even more preferably 5 to 7.

The repeating unit (b) may be a repeating unit represented by Formula (pB).

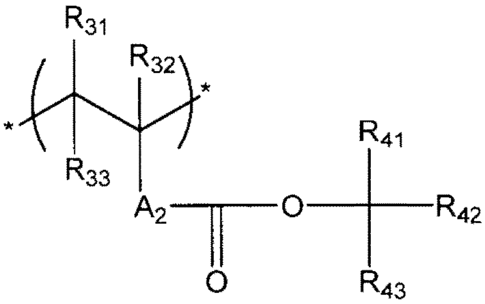

(pB)

In Formula (pB),

$R_{31}$, $R_{32}$, and $R_{33}$ each independently represent a hydrogen atom or an alkyl group.
$A_2$ represents a single bond or a divalent linking group.
$R_{41}$, $R_{42}$, and $R_{43}$ each independently represent a linear or branched alkyl group or a monocyclic or polycyclic cycloalkyl group. Here, at least one of $R_{41}$, $R_{42}$, or $R_{43}$ represents a monocyclic cycloalkyl group.

Specific examples of the alkyl group represented by $R_{31}$, $R_{32}$, and $R_{33}$ in Formula (pB) include the same specific examples exemplified in the alkyl group represented by $R_{11}$, $R_{12}$, and $R_{13}$ in Formula (1-1), and preferable specific examples are also the same.

An alkyl group represented by $R_{31}$, $R_{32}$, and $R_{33}$ may have a substituent. Examples of the preferable substituent include the same specific examples as those exemplified in the substituent that may be included in the alkyl group represented by $R_{11}$, $R_{12}$, and $R_{13}$ in Formula (I-1).

Examples of the divalent linking group represented by $A_2$ include specific examples exemplified in the divalent linking group represented by A in Formula (pA).

In one aspect of the present invention, $A_2$ is preferably a single bond.

For example, the linear or branched alkyl group represented by $R_{41}$, $R_{42}$, and $R_{43}$ is preferably a group having 1 to 4 carbon atoms such as a methyl group, an ethyl group, an n-propyl group, an isopropyl group, an n-butyl group, an isobutyl group, and a t-butyl group.

The monocyclic cycloalkyl group represented by $R_{41}$, $R_{42}$, and $R_{43}$ is preferably a cycloalkyl group having 5 to 10 carbon atoms, more preferably a cycloalkyl group having 5 to 8 carbon atoms, and even more preferably a cycloalkyl group having 5 to 7 carbon atoms.

For example, the polycyclic cycloalkyl group represented by $R_{41}$, $R_{42}$, and $R_{43}$ is preferably a polycyclic cycloalkyl group such as a norbornyl group, a tetracyclodecanyl group, a tetracyclododecanyl group, and an adamantyl group.

The resin (A) may contain two or more kinds of the repeating units (b).

Specific examples of the repeating unit (b) are provided below, but the present invention is not limited to these. In the formula, R represents a hydrogen atom or a methyl group, and Rx's each independently represent an alkyl group having 1 to 4 carbon atoms.

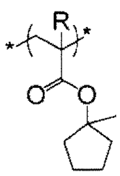 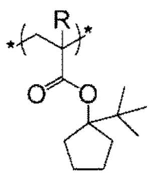 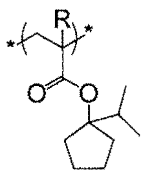 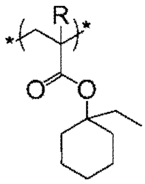 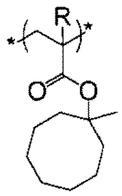 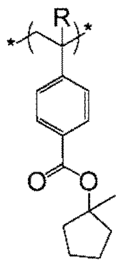

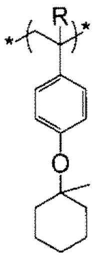 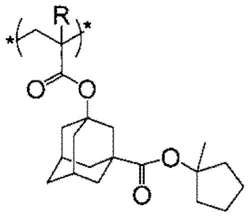 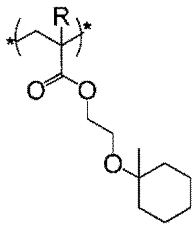 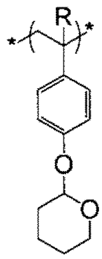

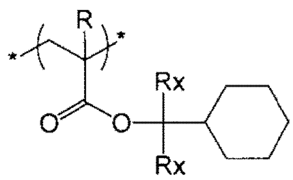 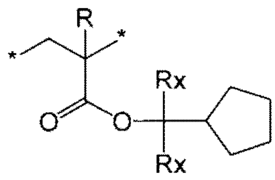 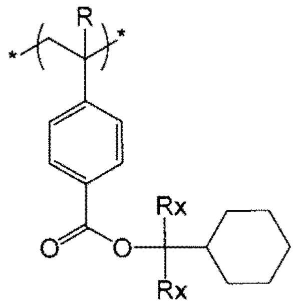

The content ratio of the repeating unit (b) (a total content ratio in a case where two or more kinds thereof are contained) is preferably 20 to 90 mol%, more preferably 25 to 80 mol%, and even more preferably 30 to 70 mol% with respect to all repeating units in the resin (A).

-Another repeating unit having acid-decomposable group protected by protective group-

The resin (A) may further contain a repeating unit that has an acid-decomposable group being decomposed due to an action of an acid and generating a carboxyl group and is different from the repeating unit (b).

The repeating unit having a group being decomposed due to an action of an acid and generating a carboxyl group is a repeating unit in which a hydrogen atom of a carboxyl group has a group that is substituted with a group decomposed due to an action of an acid to leave.

Examples of the group that leaves due to an acid include $-C(R_{36})(R_{37})(R_{38})$, $-C(R_{36})(R_{37})(OR_{39})$, and $-C(R_{01})(R_{02})(OR_{39})$.

In the formula, $R_{36}$ to $R_{39}$ each independently represent an alkyl group, a polycyclic cycloalkyl group, an aryl group, an aralkyl group, or an alkenyl group. $R_{36}$ and $R_{37}$ may be bonded to each other, so as to form a ring.

$R_{01}$ and $R_{02}$ each independently represent a hydrogen atom, a polycyclic alkyl group, a cycloalkyl group, an aryl group, an aralkyl group, or an alkenyl group.

The repeating unit having a group being decomposed due to an action of an acid and generating a carboxyl group is preferably a repeating unit represented by Formula (AI).

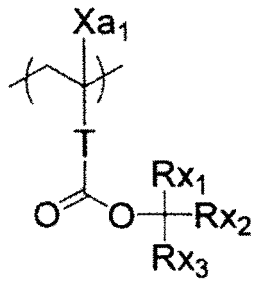

(A I)

In Formula (AI),

$Xa_1$ represents a hydrogen atom or an alkyl group that may have a substituent.
T represents a single bond or a divalent linking group.
$Rx_1$ to $Rx_3$ each independently represent a (linear or branched) alkyl group or a polycyclic cycloalkyl group. Here, in a case where all of $Rx_1$ to $Rx_3$ are (linear or branched) alkyl groups, at least two of Rxi, ..., or $Rx_3$ are preferably methyl groups.
Two of $Rx_1$ to $Rx_3$ are bonded to form a polycyclic cycloalkyl group.

Examples of the alkyl group that is represented by $Xa_1$ and may have a substituent include a methyl group or a group represented by $-CH_2-R_{11}$. $R_{11}$ represents a halogen atom (such as a fluorine atom), a, hydroxyl group, or a monovalent organic group, examples of the monovalent organic group include an alkyl group having 5 or less carbon atoms and an acyl group having 5 or less carbon atoms, and an alkyl group having 3 or less carbon atoms is preferable, and a methyl group is more preferable. According to an aspect, $Xa_1$ is preferably a hydrogen atom, a methyl group, a trifluoromethyl group, or a hydroxymethyl group.

Examples of the divalent linking group of T include an alkylene group, an arylene group, a -COO-Rt- group, and an -O-Rt- group. In the formula, Rt represents an alkylene group or a cycloalkylene group.

T is preferably a single bond, an arylene group, or a -COO-Rt- group and more preferably a single bond or an arylene group. The arylene group is preferably an arylene group having 6 to 10 carbon atoms and more preferably a phenylene group. Rt is preferably an alkylene group having 1 to 5 carbon atoms and more preferably a $-CH_2-$ group, a $-(CH_2)_2-$group, and a $-(CH_2)_3-$ group.

The alkyl group of $Rx_1$ to $Rx_3$ is preferably a group having 1 to 4 carbon atoms such as a methyl group, an ethyl group, an n-propyl group, an isopropyl group, an n-butyl group, an isobutyl group, and a t-butyl group.

The polycyclic cycloalkyl group of $Rx_1$ to $Rx_3$ is preferably a polycyclic cycloalkyl group such as a norbornyl group, a tetracyclodecanyl group, a tetracyclododecanyl group, and an adamantyl group.

The polycyclic cycloalkyl group formed by bonding two of $Rx_1$ to $Rx_3$ is preferably a polycyclic cycloalkyl group such as a norbornyl group, a tetracyclodecanyl group, a tetracyclododecanyl group, and an adamantyl group.

With respect to the polycyclic cycloalkyl group formed by bonding two of $Rx_1$ to $Rx_3$, for example, one of the methylene groups constituting the ring may be substituted with a hetero atom such as an oxygen atom or a group having a hetero atom such as a carbonyl group.

Each of the above groups may have a substituent, examples of the substituent include an alkyl group (having 1 to 4 carbon atoms), a halogen atom, a hydroxyl group, an alkoxy group (having 1 to 4 carbon atoms), a carboxyl group, and an alkoxycarbonyl group (having 2 to 6 carbon atoms), and a group having 8 or less carbon atoms is preferable.

The repeating unit represented by Formula (AI) preferably an acid-decomposable (meth)acrylic acid tertiary alkyl ester-based repeating unit (a repeating unit in which $Xa_1$ represents a hydrogen atom or a methyl group, and T represents a single bond). It is more preferable that $Rx_1$ to $Rx_3$ each independently represent a repeating unit representing a linear or branched alkyl group, it is even more preferable that $Rx_1$ to $Rx_3$ each independently represent a repeating unit representing a linear alkyl group.

Specific examples of the repeating unit that has a group being decomposed due to an action of an acid and generating a carboxyl group and is different from the repeating unit (b) are provided below, but the present invention is not limited to these.

In the specific examples, Rx and $Xa_1$ represent a hydrogen atom, $CH_3$, $CF_3$, or $CH_2OH$. Rxa and Rxb each represent an alkyl group having 1 to 4 carbon atoms. Z represents a substituent including a polar group, and in a case where there are a plurality of Z's, Z's each independently represent a substituent including a polar group. p represents 0 or a positive integer. Examples of the substituent including a polar group represented by Z include a linear or branched

alkyl group having a hydroxyl group, a cyano group, an amino group, an alkylamide group, or a sulfonamide group, and a cycloalkyl group, and the substituent is preferably an alkyl group having a hydroxyl group. The branched alkyl group is particularly preferably an isopropyl group.

As specific examples of the repeating unit having a group being decomposed due to an action of an acid and generating a carboxyl group, specific examples disclosed in [0227] to [0233] of JP2014-232309A can be referred to, and the content thereof is incorporated into the present specification.

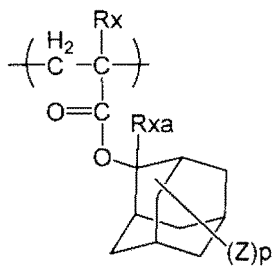
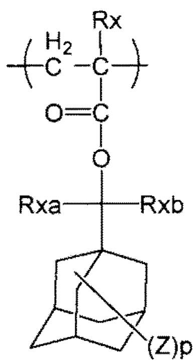
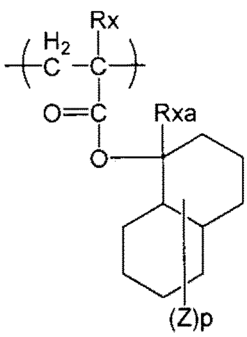
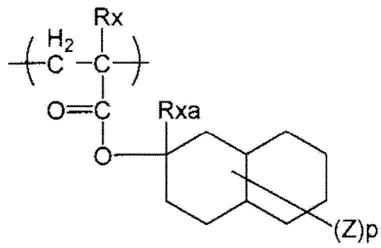

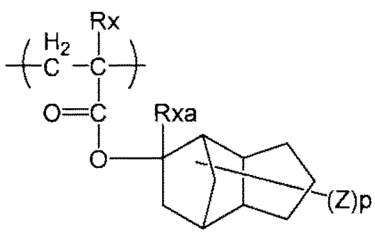
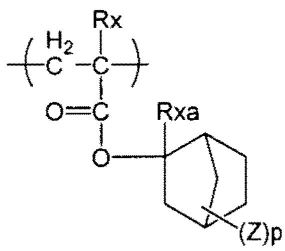
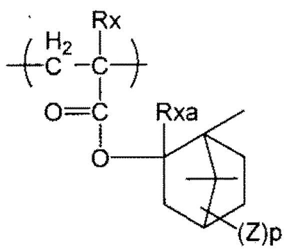

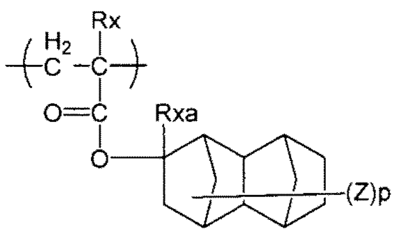
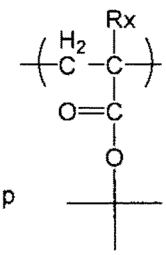

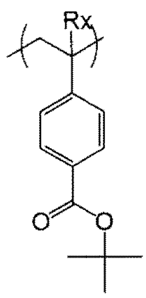
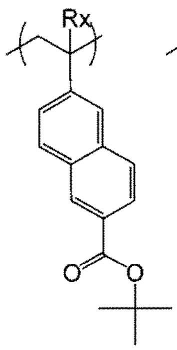
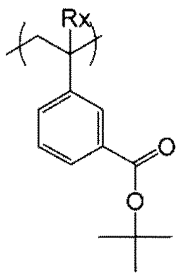

In a case where the resin (A) has a repeating unit that has a group being decomposed due to an action of an acid and generating a carboxyl group and that is different from the repeating unit (b), the content ratio of the repeating unit is preferably 20 to 90 mol%, more preferably 25 to 80 mol%, and even more preferably 30 to 70 mol% with respect to all repeating units in the resin (A).

-Repeating unit having lactone structure-

It is preferable that the resin (A) contains a repeating unit having a lactone structure.

As the lactone group, any group having a lactone structure can be used, but a group containing a lactone structure of a 5-membered to 7-membered ring is preferable, and it is preferable that another ring structure is fused to a lactone structure of 5-membered to 7-membered ring in a form of forming a bicyclo structure or a spiro structure. It is more preferable that the resin (A) has a repeating unit having a group having a lactone structure represented by any one of Formulae (LC1-1) to (LC1-17). A group having a lactone structure may be directly bonded to a main chain. The preferable lactone structure is a group represented by Formulae (LC1-1), (LC1-4), (LC1-5), (LC1-6), (LC1-13), and (LC1-14).

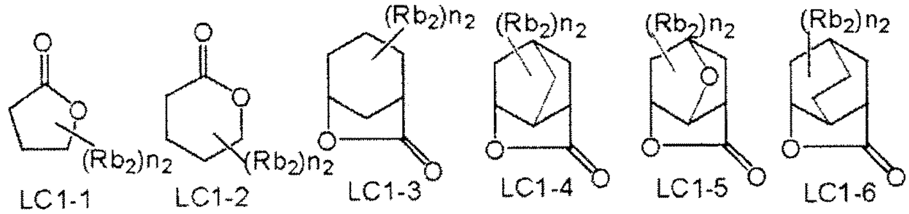

LC1-1 LC1-2 LC1-3 LC1-4 LC1-5 LC1-6

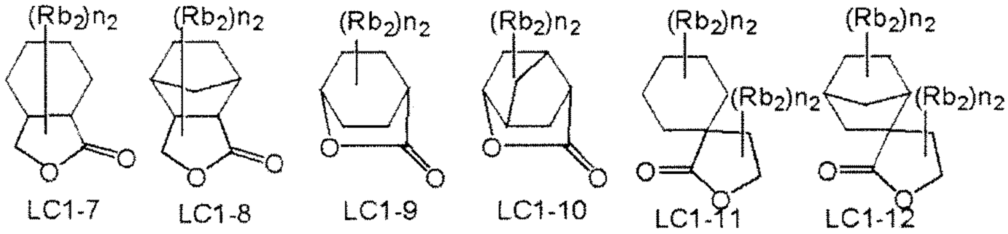

LC1-7 LC1-8 LC1-9 LC1-10 LC1-11 LC1-12

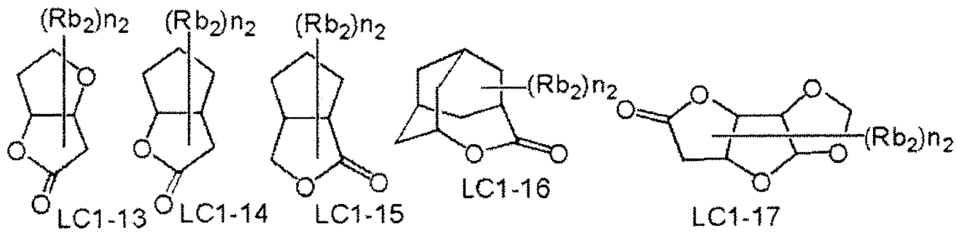

LC1-13 LC1-14 LC1-15 LC1-16 LC1-17

A lactone structure portion may have or may not have a substituent ($Rb_2$). Preferable examples of the substituent ($Rb_2$) include an alkyl group having 1 to 8 carbon atoms, a cycloalkyl group having 4 to 7 carbon atoms, an alkoxy group having 1 to 8 carbon atoms, an alkoxycarbonyl group having 1 to 8 carbon atoms, a carboxyl group, a halogen atom, a hydroxyl group, a cyano group, and an acid-decomposable group. n2 represents an integer of 0 to 4. In a case where n2 is 2 or more, the plurality of $Rb_2$'s which are present may be identical to or different from each other, and the plurality of $Rb_2$'s which are present may be bonded to each other to form a ring.

Examples of the repeating unit having a group having a lactone structure represented by any one of Formulae (LC1-1) to (LC1-17) include repeating units represented by Formula (AII).

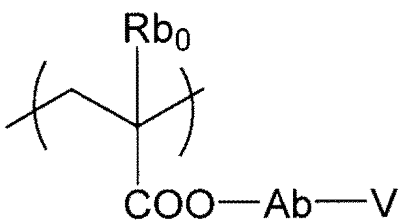

(AII)

In Formula (AII), Rbo represents a hydrogen atom, a halogen atom, or an alkyl group having 1 to 4 carbon atoms.

Examples of the preferable substituent that may be included in the alkyl group of Rbo include a hydroxyl group and a halogen atom.

Examples of the halogen atom in Rbo include a fluorine atom, a chlorine atom, a bromine atom, and an iodine

atom. $Rb_0$ is preferably a hydrogen atom or a methyl group.

Ab represents a single bond, an alkylene group, a divalent linking group having a monocyclic or polycyclic alicyclic hydrocarbon structure, an ether group, an ester group, a carbonyl group, a carboxyl group, or a divalent group obtained by combining these groups. A single bond and a linking group represented by $-Ab_1-CO_2-$ are preferable. $Ab_1$ is a linear or branched alkylene group, a monocyclic or polycyclic cycloalkylene group and preferably a methylene group, an ethylene group, a cyclohexylene group, an adamantylene group, or a norbomylene group.

V represents a group represented by any one of Formulae (LC1-1) to (LC1-17).

In the repeating unit having a group having a lactone structure, an optical isomer is usually present, but any optical isomer may be used. One optical isomer may be used singly, or a plurality of optical isomers may be used in a mixture. In a case where one kind of optical isomer is mainly used, the optical purity (ee) thereof is preferably 90 or more and more preferably 95 or more.

Specific examples of the repeating unit having a group having a lactone structure are provided below, but the present invention is not limited thereto.

(In the formula, Rx represents $CH_3$, $CH_2OH$, or $CF_3$)

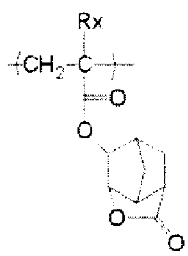
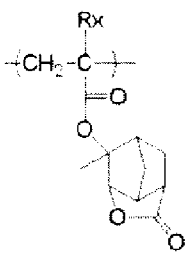
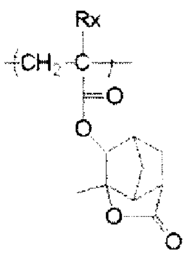
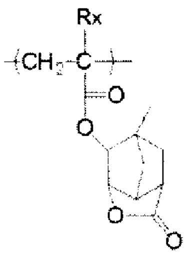
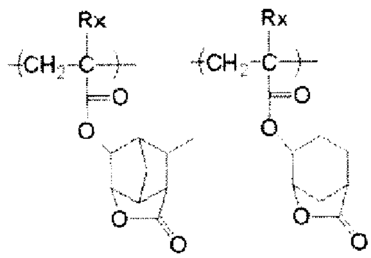

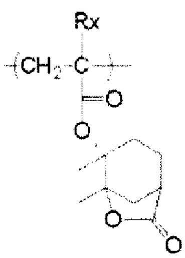
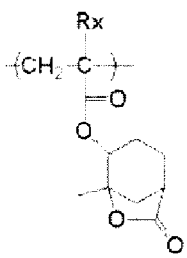
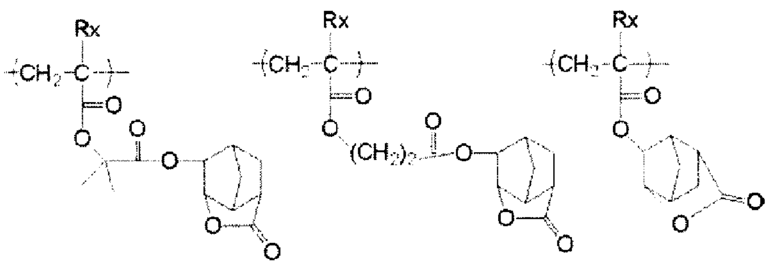

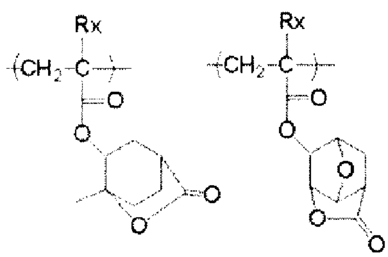
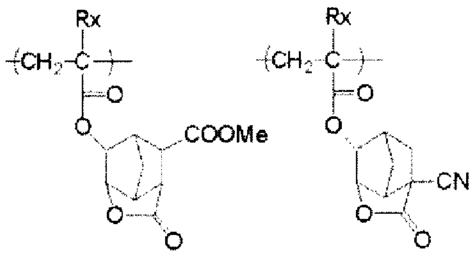
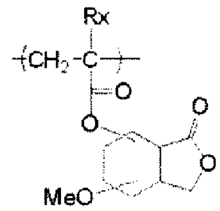

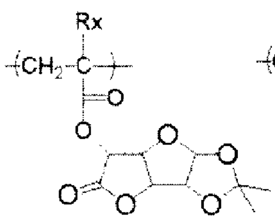
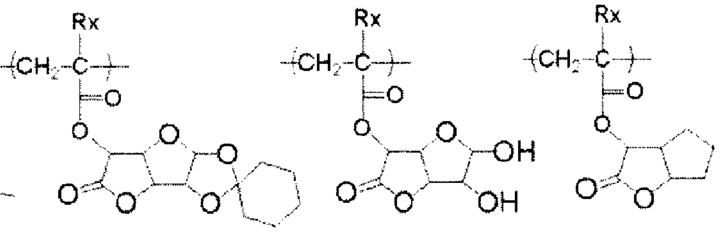

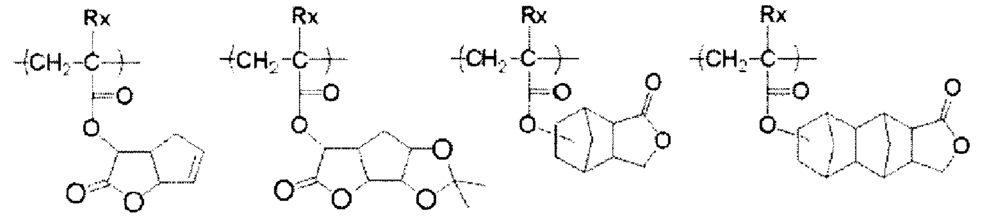

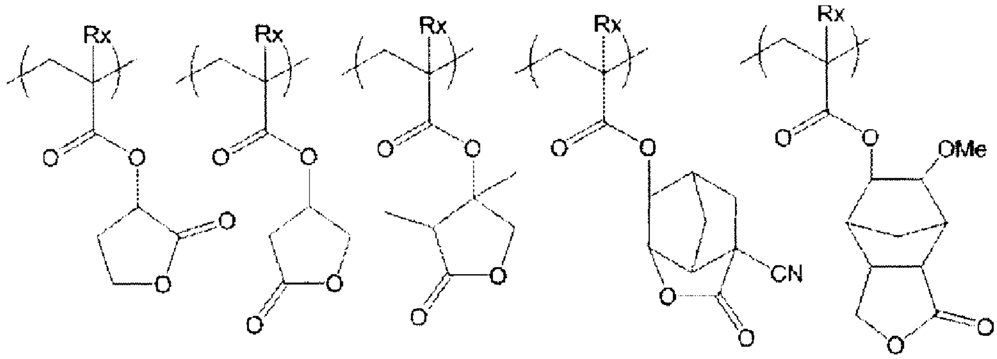

(In the formula, Rx represents $CH_3$, $CH_2OH$, or $CF_3$)

The content of the repeating unit having a lactone group is preferably 1 to 50 mol%, more preferably 5 to 45 mol%, and even more preferably 5 to 40 mol% with respect to all repeating units in the resin (A).

The resin (A) may further have a repeating unit containing an organic group having a polar group, particularly, a repeating unit having an alicyclic hydrocarbon structure substituted with a polar group.

As a result, the substrate adhesiveness and developer affinity are improved. The alicyclic hydrocarbon structure in the alicyclic hydrocarbon structure substituted with a polar group is preferably an adamantyl group, a diamantyl group, or a norbornane group. The polar group is preferably a hydroxyl group and a cyano group.

Specific examples of the repeating unit having a polar group are provided below, but the present invention is not limited thereto.

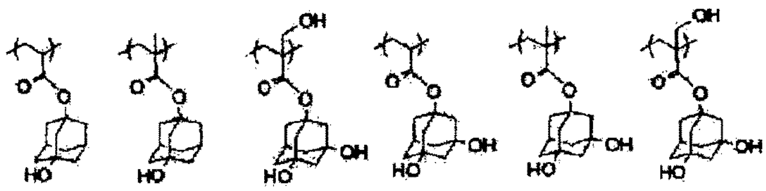

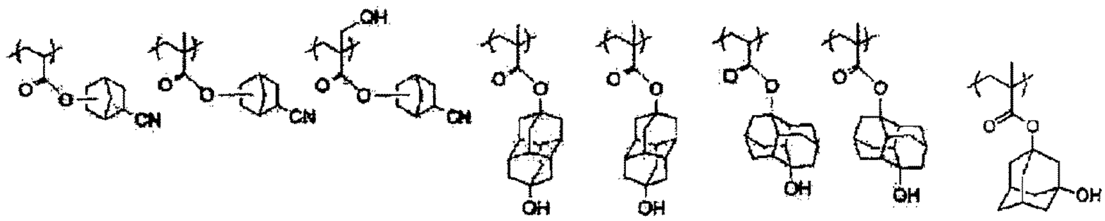

In a case where the resin (A) has a repeating unit containing an organic group having a polar group, the content thereof is preferably 1 to 30 mol%, more preferably 5 to 25 mol%, and even more preferably 5 to 20 mol% with respect to all repeating units in the resin (A).

As the repeating unit other than the above, a repeating unit having a group (photoacid generating group) that generates an acid due to irradiation with actinic rays or radiation may be included. In this case, it can be considered that this repeating unit having a photoacid generating group corresponds to the compound (B) which generates an acid due to irradiation with an actinic ray or radiation described below.

Examples of the repeating unit include a repeating unit represented by Formula (4).

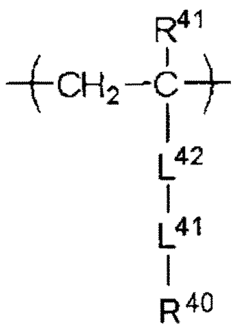

(4)

$R^{41}$ represents a hydrogen atom or a methyl group. $L^{41}$ represents a single bond or a divalent linking group. $L^{42}$ represents a divalent linking group. $R^{40}$ represents a structure moiety which is decomposed due to irradiation with actinic rays or radiation to generate an acid at a side chain.

Hereinafter, specific examples of the repeating unit represented by Formula (4) are provided, but the present invention is not limited to these.

Examples of the repeating unit represented by Formula (4) include repeating units disclosed in paragraphs [0094] to [0105] of JP2014-041327A.

In a case where the resin (A) contains a repeating unit having a photoacid generating group, the content thereof is preferably 1 to 40 mol%, more preferably 1 to 35 mol%, and even more preferably 1 to 30 mol% with respect to all repeating units in the resin (A).

The resin (A) can be synthesized by a general method (for example, radical polymerization). Examples of the general synthesis method include a batch polymerization method in which polymerization is performed by dissolving a monomer species and an initiator in a solvent and heating and a dropwise addition polymerization method in which a solution of a monomer species and an initiator is added dropwise to the heated solvent over 1 to 10 hours. The dropwise addition polymerization method is preferable.

Examples of the reaction solvent include ethers such as tetrahydrofuran, 1,4-dioxane, and diisopropyl ether, ketones such as methyl ethyl ketone and methyl isobutyl ketone, an ester solvent such as ethyl acetate, an amide solvent such as dimethylformamide and dimethylacetamide, and a solvent for dissolving the resist composition according to the present invention described below such as propylene glycol monomethyl ether acetate, propylene glycol monomethyl ether, and cyclohexanone. It is preferable to perform polymerization using the same solvent as the solvent used for the resist composition of the present invention. As a result, generation of particles during storage can be suppressed.

The polymerization reaction is preferably performed in an inert gas atmosphere such as nitrogen or argon. Polymerization is initiated by using a commercially available radical initiator (azo-based initiator, peroxide, and the like) as a polymerization initiator. The radical initiator is preferably an azo-based initiator and more preferably an azo-based initiator having an ester group, a cyano group, and a carboxyl group. Examples of the preferable initiators include azobisisobutyronitrile, azobisdimethylvaleronitrile, and dimethyl 2,2'-azobis(2-methylpropionate). An initiator is added or an initiator is added in portions as desired, and after completion of the reaction, the initiator is charged in a solvent, and the desired polymer is collected by a method such as powder, solid collection, or the like. The concentration in the reaction is 5 to 50 mass% and preferably 10 to 30 mass%. The reaction temperature is generally 10°C to 150°C, preferably 30°C to 120°C, and even more preferably 60°C to 100°C.

Purification can be performed by a general method such as a liquid-liquid extraction method in which retained monomers and oligomer components are removed by washing with water or combining appropriate solvents, a purification method in a solution state such as ultrafiltration for extracting and removing only those having a specific molecular weight or less, a reprecipitation method in which a resin solution is added dropwise into a poor solvent so as to solidify a resin in the poor solvent such that a retained monomer or the like is removed, and a purification method in a solid state in which a filtered resin slurry is washed with a poor solvent.

The weight-average molecular weight of the resin (A) is preferably 1,000 to 200,000, more preferably 3,000 to 20,000, and most preferably 5,000 to 15,000, as a value in terms of polystyrene by a GPC method. In a case where the weight-average molecular weight is caused to be 1,000 to 200,000, it is possible to prevent deterioration of heat resistance and dry etching resistance and it is possible to prevent deterioration of developability and deterioration of film formability due to increase in viscosity.

According to another particularly preferable aspect, the weight-average molecular weight of the resin (A) is 3,000 9,500, as a value in terms of polystyrene by a GPC method. By setting the weight-average molecular weight to be 3,000 to 9,500, particularly, a resist residue (hereinafter also referred to as "scum") is suppressed, and a better pattern can be formed.

The dispersion degree (molecular weight distribution) is generally in the range of 1 to 5, preferably in the range

of 1 to 3, more preferably in the range of 1.2 to 3.0, and particularly preferably in the range of 1.2 to 2.0. As the dispersion degree is smaller, a resolution and a resist shape are excellent, a sidewall of a resist pattern is smooth, and roughness properties are excellent.

In the actinic ray-sensitive or radiation-sensitive resin composition according to the embodiment of the present invention, the content ratio of the resin (A) is preferably 50 to 99.9 mass% and more preferably 60 to 99.0 mass% with respect to the total solid content.

According to the actinic ray-sensitive or radiation-sensitive resin composition, the resin (A) may be used singly, or two or more kinds thereof may be used in combination.

<(B) Compound that generates acid by irradiation with actinic ray or radiation>

The actinic ray-sensitive or radiation-sensitive resin composition according to the embodiment of the present invention contains a compound (hereinafter, referred to as a "photoacid generator (PAG)" or the "compound (B)") that generates an acid due to the irradiation with actinic rays or radiation.

The photoacid generator may have an aspect of a low molecular weight compound or may have an aspect of being incorporated into a part of the polymer. The aspect of a low molecular weight compound and the aspect of being incorporated into a part of a polymer may be used in combination.

In a case of an aspect in which the photoacid generator is a low molecular weight compound, the molecular weight is preferably 3,000 or less, more preferably 2,000 or less, and even more preferably 1,000 or less.

In a case where the photoacid generator is in an aspect of being incorporated into a part of the polymer, the acid generator may be incorporated into a part of the resin (A) or may be incorporated into a resin different from the resin (A).

For the purpose of adjusting the pattern cross-sectional shape, the number of fluorine atoms included in the acid generator is appropriately adjusted. By adjusting the fluorine atom, the uneven distribution properties of the surface of the acid generator in the resist film can be controlled. As the number of the fluorine atoms included in the acid generator is large, the acid generator is distributed more unevenly on the surface.

According to the present invention, the photoacid generator is preferably in an aspect of a low molecular weight compound.

The photoacid generator is not particularly limited as long as it is a well-known photoacid generator but is preferably a compound that generates at least one of organic acid, for example, sulfonic acid, bis(alkylsulfonyl) imide, or tris(alkylsulfonyl) methide, due to the irradiation with actinic ray or radiation, preferably electron beams or extreme ultraviolet rays.

It is more preferable that examples thereof include compounds represented by Formulae (ZI), (ZII), and (ZIII).

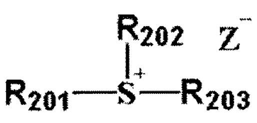 (ZI) 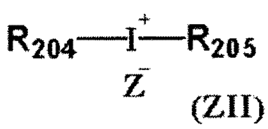 (ZII) 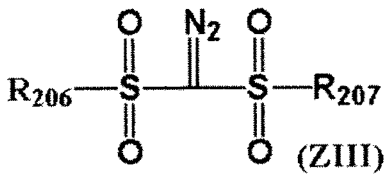 (ZIII)

In Formula (ZI),

$R_{201}$, $R_{202}$, and $R_{203}$ each independently represent organic groups.

The number of carbon atoms of the organic group as $R_{201}$, $R_{202}$, and $R_{203}$ is generally 1 to 30 and preferably 1 to 20.

Two of $R_{201}$ to $R_{203}$ may be bonded to each other to form a ring structure and may contain an oxygen atom, a sulfur atom, an ester bond, an amide bond, or a carbonyl group in the ring. Examples of the group formed by bonding two of $R_{201}$ to $R_{203}$ include an alkylene group (for example, a butylene group and a pentylene group).

$Z^-$ represents a non-nucleophilic anion (anion markedly low ability of causing a nucleophilic reaction).

Examples of the non-nucleophilic anion include a sulfonate anion (aliphatic sulfonate anion, aromatic sulfonate anion, and camphor sulfonate anion), a carboxylate anion (aliphatic carboxylate anion, aromatic carboxylate anion, and aralkyl carboxylate anion), a sulfonylimide anion, a bis(alkylsulfonyl) imide anion, and a tris(alkylsulfonyl) methide anion.

The aliphatic moiety in the aliphatic sulfonate anion and the aliphatic carboxylate anion may be an alkyl group or a cycloalkyl group, and is preferably a linear or branched alkyl group having 1 to 30 carbon atoms and a cycloalkyl group having 3 to 30 carbon atoms.

The aromatic group in the aromatic sulfonate anion and the aromatic carboxylate anion is preferably an aryl group having 6 to 14 carbon atoms, and examples thereof include a phenyl group, a tolyl group, and a naphthyl group.

The alkyl group and the cycloalkyl group, and the aryl group may have a substituent. Specific examples thereof

include a nitro group, a halogen atom such as a fluorine atom, a carboxyl group, a hydroxyl group, an amino group, a cyano group, an alkoxy group (preferably having 1 to 15 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), an alkoxycarbonyloxy group (preferably having 2 to 7 carbon atoms), an alkylthio group (preferably having 1 to 15 carbon atoms), an alkylsulfonyl group (preferably having 1 to 15 carbon atoms), an alkyliminosulfonyl group (preferably having 1 to 15 carbon atoms), an aryloxysulfonyl group (preferably having 6 to 20 carbon atoms), an alkylaryloxysulfonyl group (preferably having 7 to 20 carbon atoms), a cycloalkylaryloxysulfonyl group (preferably having 10 to 20 carbon atoms), an alkyloxyalkyloxy group (preferably having 5 to 20 carbon atoms), and a cycloalkylalkyloxyalkyloxy group (preferably having 8 to 20 carbon atoms). With respect to the aryl group and the ring structure of each group, examples of the substituent further include an alkyl group (preferably having 1 to 15 carbon atoms).

The aralkyl group in the aralkylcarboxylate anion is preferably an aralkyl group having 7 to 12 carbon atoms, and examples thereof include a benzyl group, a phenethyl group, a naphthylmethyl group, a naphthylethyl group, and a naphthylbutyl group.

Examples of the sulfonylimide anion include a saccharin anion.

The alkyl group in the bis(alkylsulfonyl) imide anion and the tris(alkylsulfonyl) methide anion is preferably an alkyl group having 1 to 5 carbon atoms. Examples of the substituent of these alkyl groups include a halogen atom, an alkyl group substituted with a halogen atom, an alkoxy group, an alkylthio group, an alkyloxysulfonyl group, an aryloxysulfonyl group, and a cycloalkylaryloxysulfonyl group, and a fluorine atom or an alkyl group substituted with a fluorine atom is preferable.

The alkyl group in the bis(alkylsulfonyl) imide anion may be bonded to each other to form a ring structure. This increases the acid strength.

Examples of other non-nucleophilic anions include phosphorus fluoride (for example, $PF_6^-$), boron fluoride (for example, $BF_4^-$), and antimony fluoride (for example, $SbF_6^-$).

The non-nucleophilic anion is preferably an aliphatic sulfonate anion in which at least an $\alpha$-position of the sulfonic acid is substituted with a fluorine atom, an aromatic sulfonate anion substituted with a fluorine atom or a group having a fluorine atom, a bis(alkylsulfonyl) imide anion in which an alkyl group is substituted with a fluorine atom, and a tris(alkylsulfonyl) methide anion in which an alkyl group is substituted with a fluorine atom. The non-nucleophilic anion is more preferably a perfluoroaliphatic sulfonate anion (more preferably having 4 to 8 carbon atoms) and a benzene sulfonate anion having a fluorine atom and is even more preferably a nonafluorobutanesulfonate anion, a perfluorooctanesulfonate anion, a pentafluorobenzenesulfonate anion, and a 3,5-bis(trifluoromethyl) benzenesulfonate anion.

In view of the acid strength, it is preferable that pKa of the generated acid is -1 or less, to improve sensitivity.

As a preferable aspect of the non-nucleophilic anion, an anion represented by Formula (AN1) is also provided.

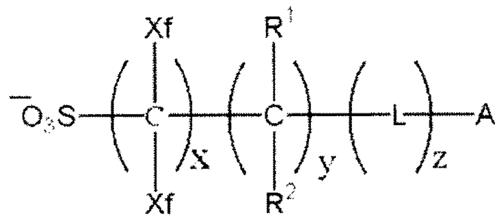

(AN1)

In the formula,

Xf' s each independently represents a fluorine atom or an alkyl group substituted with at least one fluorine atom.

$R^1$ and $R^2$ each independently represent a hydrogen atom, a fluorine atom, or an alkyl group, $R^{1'}$s and $R^{2'}$s in a case where a plurality thereof are present may be identical to or different from each other, respectively.

L represents a divalent linking group, and L's in a case where a plurality thereof are present may be identical to or different from each other.

A represents a cyclic organic group.

x represents an integer of 1 to 20, y represents an integer of 0 to 10, and z represents an integer of 0 to 10.

Formula (AN1) is more specifically described.

The alkyl group in the alkyl group substituted with a fluorine atom of Xf is preferably an alkyl group having 1 to 10 carbon atoms and more preferably an alkyl group having 1 to 4 carbon atoms. The alkyl group substituted with a fluorine atom of Xf is preferably a perfluoroalkyl group.

Xf is preferably a fluorine atom or a perfluoroalkyl group having 1 to 4 carbon atoms. Specific examples of Xf include a fluorine atom, $CF_3$, $C_2F_5$, $C_3F_7$, $C_4F_9$, $CH_2CF_3$, $CH_2CH_2CF_3$, $CH_2C_2F_5$, $CH_2CH_2C_2F_5$, $CH_2C_3F_7$, $CH_2CH_2C_3F_7$,

$CH_2C_4F_9$, and $CH_2CH_2C_4F_9$, and among these, a fluorine atom and $CF_3$ are preferable. Particularly, it is preferable that both Xf's are fluorine atoms.

The alkyl groups as $R^1$ and $R^2$ each may have a substituent (preferably a fluorine atom), and an alkyl group having 1 to 4 carbon atoms is preferable. A perfluoroalkyl group having 1 to 4 carbon atoms is more preferable. Specific examples of the alkyl group having substituents of $R^1$ and $R^2$ include $CF_3$, $C_2F_5$, $C_3F_7$, $C_4F_9$, $C_5F_{11}$, $C_6F_{13}$, $C_7F_{15}$, $C_8F_{17}$, $CH_2CF_3$, $CH_2CH_2CF_3$, $CH_2C_2F_5$, $CH_2CH_2C_2F_5$, $CH_2C_3F_7$, $CH_2CH_2C_3F_7$, $CH_2C_4F_9$, and $CH_2CH_2C_4F_9$, and among these, $CF_3$ is preferable.

$R^1$ and $R^2$ is preferably a fluorine atom or $CF_3$.

x is preferably 1 to 10 and more preferably 1 to 5.

y is preferably 0 to 4 and more preferably 0.

z is preferably 0 to 5 and more preferably 0 to 3.

The divalent linking group of L is not particularly limited, examples thereof include -COO-, -OCO-, -CO-, -O-, -S-, -SO-, $-SO_2-$, an alkylene group, a cycloalkylene group, an alkenylene group, or a linking group obtained by linking a plurality of these, and a linking group having 12 or less carbon atoms in total is preferable. Among these, -COO-, -OCO-, -CO-, and -O- are preferable, and -COO- and -OCO- are more preferable.

The cyclic organic group of A is not particularly limited as long as the cyclic organic group has a cyclic structure, and examples thereof include an alicyclic group, an aryl group, a heterocyclic group (including not only those having aromaticity but also those having no aromaticity).

The alicyclic group may be monocyclic or polycyclic, and is preferably a monocyclic cycloalkyl group such as a cyclopentyl group, a cyclohexyl group, and a cyclooctyl group, and a polycyclic cycloalkyl group such as a norbornyl group, a tricyclodecanyl group, a tetracyclodecanyl group, a tetracyclododecanyl group, and an adamantyl group. Among these, an alicyclic group having a bulky structure having 7 or more carbon atoms such as a norbornyl group, a tricyclodecanyl group, a tetracyclodecanyl group, a tetracyclododecanyl group, and an adamantyl group is preferable, in view of suppressing diffusion in the film in the heating after exposure step and improvement of a mask error enhancement factor (MEEF).

Examples of the aryl group include a benzene ring, a naphthalene ring, a phenanthrene ring, and an anthracene ring.

Examples of the heterocyclic group include groups derived from a furan ring, a thiophene ring, a benzofuran ring, a benzothiophene ring, a dibenzofuran ring, a dibenzothiophene ring, and a pyridine ring. Among them, ones derived from a furan ring, a thiophene ring, and a pyridine ring are preferable.

Examples of the cyclic organic group include a lactone structure, and specific examples thereof include a lactone structure represented by Formulae (LC1-1) to (LC1-17).

The cyclic organic group may have a substituent, and examples of the substituent includes an alkyl group (may be any one of a linear group, a branched group, or a cyclic group and preferably having 1 to 12 carbon atoms), a cycloalkyl group (may be either any one of a monocyclic ring, a polycyclic ring, or a spiro ring and preferably having 3 to 20 carbon atoms), an aryl group (preferably having 6 to 14 carbon atoms), a hydroxy group, an alkoxy group, an ester group, an amide group, a urethane group, a ureido group, a thioether group, a sulfonamide group, and a sulfonic acid ester group. Carbon constituting the cyclic organic group (carbon contributing to ring formation) may be carbonyl carbon.

Examples of the organic groups of $R_{201}$, $R_{202}$, and $R_{203}$ each include an aryl group, an alkyl group, or a cycloalkyl group.

It is preferable that at least one of $R_{201}$, $R_{202}$, or $R_{203}$ an aryl group, and it is more preferable that all of the three are aryl groups. In addition to a phenyl group and a naphthyl group, as the aryl group, a heteroaryl group such as an indole residue or a pyrrole residue is also exemplified. The alkyl group and the cycloalkyl group of $R_{201}$ to $R_{203}$ each are preferably a linear or branched alkyl group having 1 to 10 carbon atoms, and a cycloalkyl group having 3 to 10 carbon atoms. The alkyl group is more preferably a methyl group, an ethyl group, an n-propyl group, an i-propyl group, and an n-butyl group. The cycloalkyl group is more preferably a cyclopropyl group, a cyclobutyl group, a cyclopentyl group, a cyclohexyl group, and a cycloheptyl group. These groups may further have a substituent. Examples the substituent include a halogen atom such as a nitro group and a fluorine atom, a carboxyl group, a hydroxyl group, an amino group, a cyano group, an alkoxy group (preferably having 1 to 15 carbon atoms), a cycloalkyl group (preferably having 3 to 15 carbon atoms), an aryl group (preferably having 6 to 14 carbon atoms), an alkoxycarbonyl group (preferably having 2 to 7 carbon atoms), an acyl group (preferably having 2 to 12 carbon atoms), and an alkoxycarbonyloxy group (preferably having 2 to 7 carbon atoms), and the present invention is not limited to these.

Preferable examples of the anion represented by Formula (AN1) are provided as below. In the following examples, A represents a cyclic organic group.

$SO_3$-$CF_2$-$CH_2$-OCO-A, $SO_3$-$CF_2$-CHF-$CH_2$-OCO-A, $SO_3$-$CF_2$-COO-A, $SO_3$-$CF_2$-$CF_2$-$CH_2$-A, and $SO_3$-$CF_2$-CH($CF_3$)-OCO-A

In Formulae (ZII) and (ZIII),

$R_{204}$ to $R_{207}$ each independently represent an aryl group, an alkyl group, or a cycloalkyl group.

The aryl group, the alkyl group, and the cycloalkyl group of $R_{204}$ to $R_{207}$ are the same as the aryl group described in the aryl group, the alkyl group, and the cycloalkyl group of $R_{201}$ to $R_{203}$ in the Formula (ZI).

An aryl group, an alkyl group, and a cycloalkyl group of $R_{204}$ to $R_{207}$ each may have a substituent. Examples of the substituent include a substituent that may be included in an aryl group, an alkyl group, and a cycloalkyl group of $R_{201}$ to $R_{203}$ in the Formula (ZI).

$Z^-$ represents a non-nucleophilic anion, and examples thereof include the same as the non-nucleophilic anion of $Z^-$ in Formula (ZI).

According to the present invention, in view of suppressing diffusion of an acid generated by exposure to a non-exposed portion and improving resolution, by the irradiation with an electron beam or an extreme ultraviolet ray, the photoacid generator is preferably a compound that generates an acid (more preferably a sulfonic acid) having a size of a volume of 130 $Å^3$ (10 Å = 1 nm) or more, more preferably a compound that generates an acid (more preferably a sulfonic acid) having a size of a volume of 190 $Å^3$ or more, even more preferably a compound that generates an acid (more preferably a sulfonic acid) having a size of a volume of 270$Å^3$ or more, and particularly preferably a compound that generates an acid (more preferably a sulfonic acid) having a size of a volume of 400$Å^3$ or more. Here, in view of sensitivity or coating solvent solubility, the above volume is preferably 2,000 $Å^3$ or less and is more preferably 1,500 $Å^3$ or less. The above volume value was obtained by using "WinMOPAC" manufactured by Fujitsu Limited. That is, first, the chemical structure of the acid according to each example is inputted, then this structure is used as an initial structure to determine the most stable conformation of each acid by molecular force field calculation using an MM3 method, and then a PM3 method is used according to the most stable conformation so as to perform the molecular orbital calculation, such that the "accessible volume" of each acid can be calculated.

As the photoacid generator, paragraphs [0368] to [0377] of JP2014-041328Aand [0240] to [0262] ([0339] of corresponding US2015/0004533A) of JP2013-228681A can be referred to, and the contents thereof is incorporated into the present specification. Preferable specific examples thereof include the following compounds, but the present invention is not limited to these.

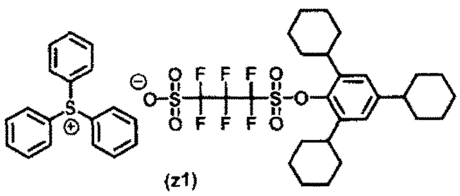
(z1)

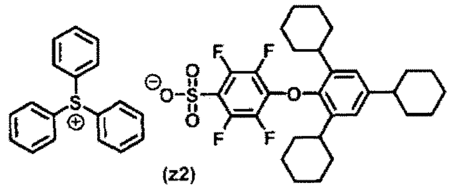
(z2)

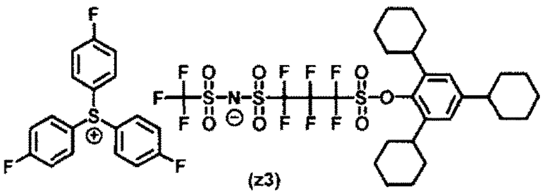
(z3)

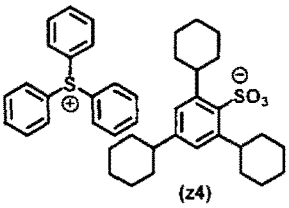
(z4)

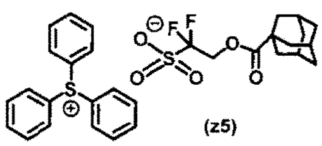
(z5)

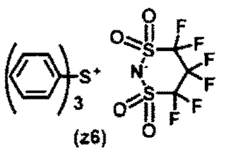
(z6)

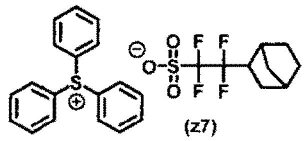
(z7)

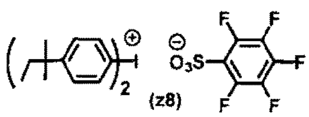
(z8)

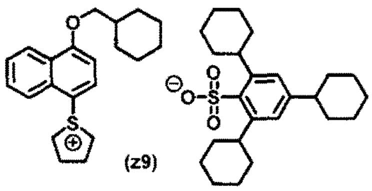
(z9)

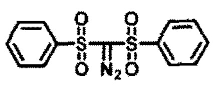
(z10)

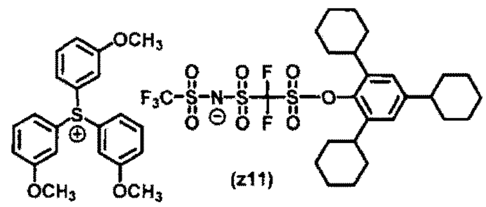

(z11)

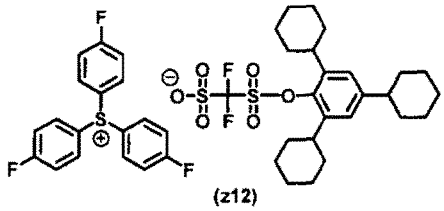

(z12)

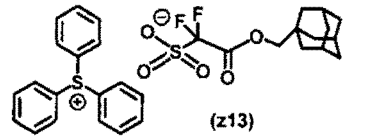

(z13)

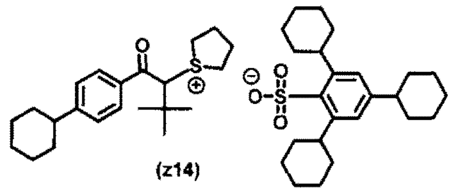

(z14)

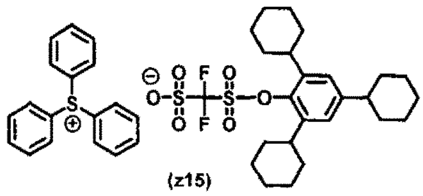

(z15)

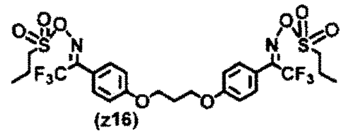

(z16)

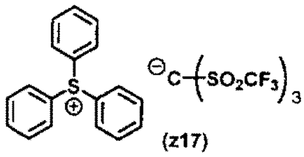

(z17)

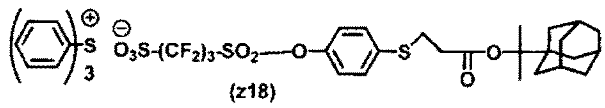

(z18)

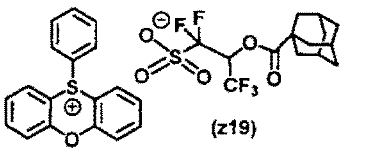

(z19)

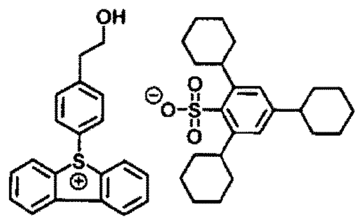

(z20)

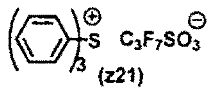

(z21)

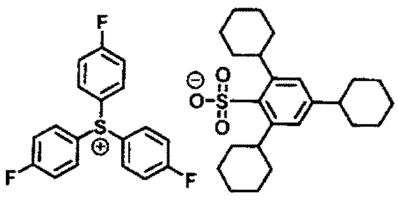

(z22)

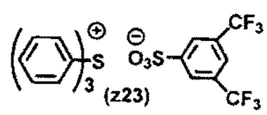

(z23)

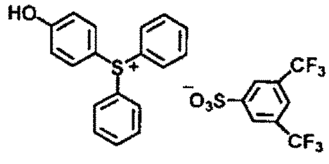

(z24)

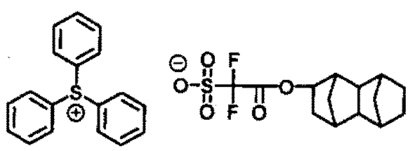

(z25)

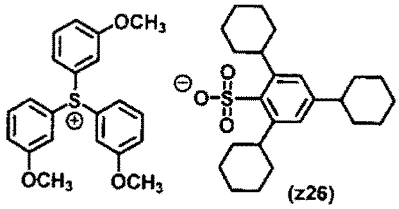
(z26)

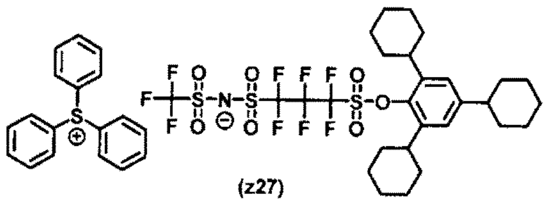
(z27)

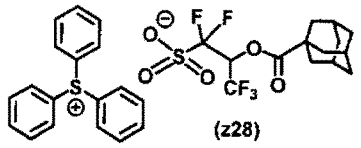
(z28)

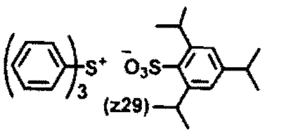
(z29)

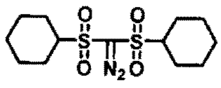
(z30)

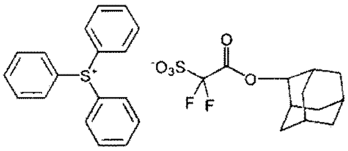
(z31)

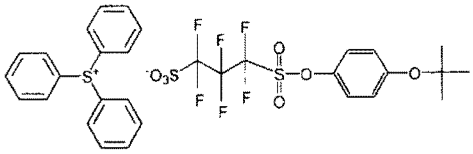
(z32)

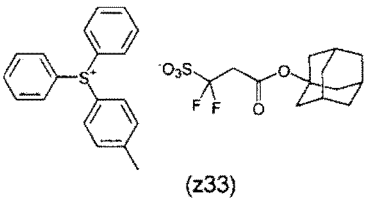
(z33)

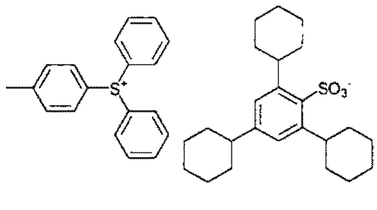
(z34)

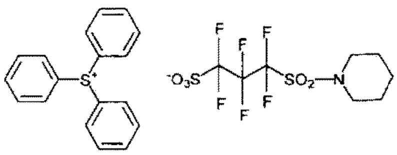
(z35)

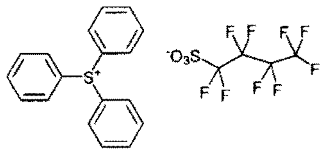
(z36)

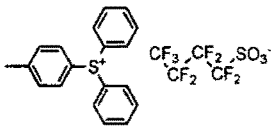
(z37)

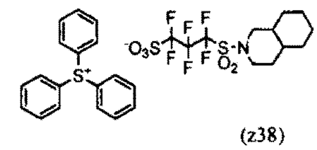
(z38)

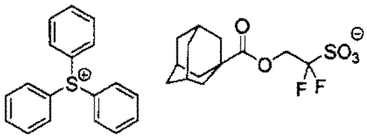

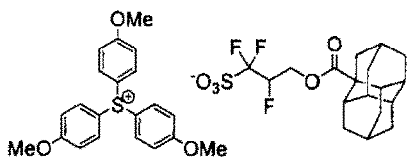

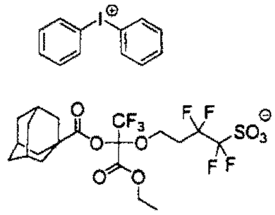

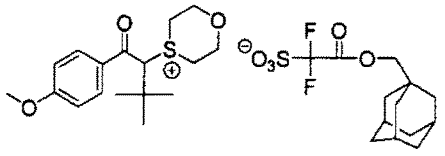

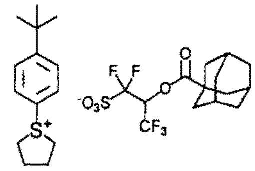

The photoacid generator may be used singly, or two or more kinds thereof may be used in combination.

The content of the photoacid generator in the actinic ray-sensitive or radiation-sensitive resin composition is preferably 0.1 to 50 mass%, more preferably 5 to 50 mass%, and even more preferably 8 to 40 mass% with respect to the total solid content of the composition. Particularly, in order to achieve both high sensitivity and high resolution in a case of the electron beam or extreme ultraviolet exposure, the content ratio of the photoacid generator is preferably high, more preferably 10 to 40 mass%, and most preferably 10 to 35 mass%.

<Solvent>

The actinic ray-sensitive or radiation-sensitive resin composition used in the present invention preferably includes a solvent (also referred to as a "resist solvent"). The solvent may include an isomer (a compound having the same number of atoms and different structures). Only one kind of isomers may be included, or a plurality of kinds of isomers may be included. The solvent preferably contains at least one of (M1) propylene glycol monoalkyl ether carboxylate or (M2) at least one selected from the group consisting of propylene glycol monoalkyl ether, lactic acid ester, acetic acid ester, alkoxypropionic acid ester, chain ketone, cyclic ketone, lactone, and alkylene carbonate. The solvent may further include a component in addition to the components (M1) and (M2).

The component (M1) is preferably at least one selected from the group consisting of propylene glycol monomethyl ether acetate, propylene glycol monomethyl ether propionate, and propylene glycol monoethyl ether acetate and particularly preferably propylene glycol monomethyl ether acetate.

The following is preferable as the component (M2).

As the propylene glycol monoalkyl ether, propylene glycol monomethyl ether and propylene glycol monoethyl ether are preferable.

As the lactic acid ester, ethyl lactate, butyl lactate, or propyl lactate is preferable.

Examples of the acetic acid ester include methyl acetate, ethyl acetate, butyl acetate, isobutyl acetate, propyl acetate, isoamyl acetate, methyl formate, ethyl formate, butyl formate, propyl formate, and 3-methoxybutyl acetate.

Butyl butyrate is also preferable.

As the alkoxypropionic acid ester, methyl 3-methoxypropionate (MMP) or ethyl 3-ethoxypropionate (EEP) is preferable.

As the chain ketone, 1-octanone, 2-octanone, 1-nonanone, 2-nonanone, acetone, 4-heptanone, 1-hexanone, 2-hexanone, diisobutyl ketone, phenyl acetone, methyl ethyl ketone, methyl isobutyl ketone, acetylacetone, acetonylacetone, ionone, diacetyl alcohol, acetyl carbinol, acetophenone, methyl naphthyl ketone, and methyl amyl ketone are preferable.

As the cyclic ketone, methyl cyclohexanone, isophorone, or cyclohexanone is preferable.

As the lactone, γ-butyrolactone is preferable.

As the alkylene carbonate, propylene carbonate is preferable.

The component (M2) is more preferably propylene glycol monomethyl ether, ethyl lactate, ethyl 3-ethoxypropionate, methyl amyl ketone, cyclohexanone, butyl acetate, pentyl acetate, γ-butyrolactone, or propylene carbonate.

In addition to the above components, an ester-based solvent having 7 or more carbon atoms (preferably 7 to 14 carbon atoms, more preferably 7 to 12 carbon atoms, and even more preferably 7 to 10 carbon atoms) and having 2 or less hetero atoms is preferably used.

Preferable examples of the ester-based solvent having 7 or more carbon atoms and having 2 or less hetero atoms include amyl acetate, 2-methylbutyl acetate, 1-methylbutyl acetate, hexyl acetate, pentyl propionate, hexyl propionate, butyl propionate, isobutyl propionate, heptyl propionate, and butyl butanoate, and isoamyl acetate is particularly preferably used.

As the component (M2), a component having a flash point (hereinafter also referred to as fp) of 37°C or higher is preferably used. Preferable examples of the component (M2) include propylene glycol monomethyl ether (fp: 47°C), ethyl lactate (fp: 53°C), ethyl 3-ethoxypropionate (fp: 49°C), methyl amyl ketone (fp: 42°C), cyclohexanone (fp: 44°C), pentyl acetate (fp: 45°C), methyl 2-hydroxyisobutyrate (fp: 45°C), γ-butyrolactone (fp: 101°C), and propylene carbonate (fp: 132°C). Among these, propylene glycol monoethyl ether, ethyl lactate, pentyl acetate, or cyclohexanone are more preferable, and propylene glycol monoethyl ether or ethyl lactate is particularly preferable. Here, the "flash point" means a value disclosed in a reagent catalog of Tokyo Chemical Industry Co., Ltd. or Sigma-Aldrich Co. LLC.

It is preferable that the solvent contains the component (M1). It is more preferable that the solvent is substantially formed only of the component (M1) or a mixed solvent of the component (M1) and other components. In the latter case, it is more preferred that the solvent contains both of the components (M1) and (M2).

The mass ratio of the components (M1) and (M2) is preferably in the range of 100:0 to 15:85, more preferably in the range of 100:0 to 40:60, and even more preferably in the range of 100:0 to 60:40. That is, it is preferable that the solvent is formed only of the component (M1), or both of the components (M1) and (M2), and the mass ratio thereof is as follows. That is, in the latter case, the mass ratio of the component (M1) to the component (M2) is preferably 15/85 or more, more preferably 40/60 or more, and even more preferably 60/40 or more. In a case where the configuration is employed, the number of development defects can be further reduced.

In a case where the solvent includes both of the components (M1) and (M2), the mass ratio of the component (M1) to the component (M2) is, for example, 99/1 or less.

As described above, the solvent may further contain components in addition to the components (M1) and (M2). In this case, the content of the components in addition to the components (M1) and (M2) is preferably in the range of 5 mass% to 30 mass% with respect to the total amount of the solvent.

The content ratio of the solvent included in the actinic ray-sensitive or radiation-sensitive resin composition is determined such that the concentration of solid contents of the total component is preferably determined to be 0.5 to 30 mass% and more preferably determined to be 1 to 20 mass%. In this manner, the coatability of the actinic ray-sensitive or radiation-sensitive resin composition can be further improved.

The concentration of solid contents of the actinic ray-sensitive or radiation-sensitive resin composition can be appropriately adjusted for the purpose of adjusting the thickness of the formed resist film.

<Basic compound>

The actinic ray-sensitive or radiation-sensitive resin composition according to the embodiment of the present invention preferably contains a basic compound in order to reduce the performance change due to the elapse of time from exposure to heating.

Preferable examples of the basic compound include compounds having structures represented by Formulae (A) to (E).

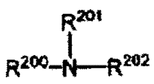
(A)

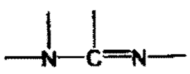
(B)

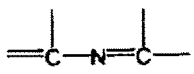
(C)

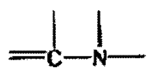
(D)

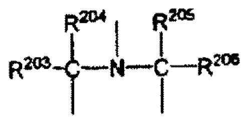
(E)

In Formulae (A) and (E), $R^{200}$, $R^{201}$, and $R^{202}$ may be identical to or different from each other, and represent hydrogen atoms, alkyl groups (preferably having 1 to 20 carbon atoms), cycloalkyl groups (preferably having 3 to 20 carbon atoms), or aryl groups (preferably having 6 to 20 carbon atoms). Here, $R^{201}$ and $R^{202}$ may be bonded to each other, so as to form a ring.

With respect to the alkyl group, the alkyl group having the substituent is preferably an aminoalkyl group having 1 to 20 carbon atoms, a hydroxyalkyl group having 1 to 20 carbon atoms, or a cyanoalkyl group having 1 to 20 carbon atoms.

$R^{203}$, $R^{204}$, $R^{205}$, and $R^{206}$ may be identical to or different from each other, and each represent an alkyl group having 1 to 20 carbon atoms.

The alkyl groups in General Formulae (A) and (E) are preferably unsubstituted.

Preferable examples of the compounds include guanidine, aminopyrrolidine, pyrazole, pyrazoline, piperazine, aminomorpholine, aminoalkylmorpholine, and piperidine. More preferable examples of the compound include compounds having an imidazole structure, a diazabicyclo structure, an onium hydroxide structure, an onium carboxylate structure, a trialkylamine structure, an aniline structure, or a pyridine structure, an alkylamine derivative having a hydroxyl group and/or an ether bond, and an aniline derivative having a hydroxyl group and/or an ether bond.

Preferable examples of the basic compound include an amine compound having a phenoxy group, and an ammonium salt compound having a phenoxy group.

As the amine compound, a primary, secondary, or tertiary amine compound can be used, and an amine compound in which at least one alkyl group is bonded to a nitrogen atom is preferable. The amine compound is more preferably a tertiary amine compound. With respect to the amine compound, as long as at least one alkyl group (preferably having from 1 to 20 carbon atoms) is bonded to a nitrogen atom, in addition to the alkyl group, a cycloalkyl group (preferably having 3 to 20 carbon atoms) or an aryl group (preferably 6 to 12 carbon atoms) may be bonded to a nitrogen

atom.

It is preferable that the amine compound has an oxygen atom in the alkyl chain, and an oxyalkylene group is formed. The number of the oxyalkylene group is 1 or more, preferably 3 to 9, and more preferably 4 to 6 in a molecule. Among oxyalkylene groups, an oxyethylene group ($-CH_2CH_2O-$) or an oxypropylene group ($-CH(CH_3)CH_2O-$ or $-CH_2CH_2CH_2O-$) is preferable, and an oxyethylene group is more preferable.

As the ammonium salt compound, a primary, secondary, tertiary, or quaternary ammonium salt compound can be used, and an ammonium salt compound in which at least one alkyl group is bonded to a nitrogen atom is preferable. With respect to the ammonium salt compound, as long as at least one alkyl group (preferably having 1 to 20 carbon atoms) is bonded to the nitrogen atom, in addition to the alkyl group, a cycloalkyl group (preferably having 3 to 20 carbon atoms) or an aryl group (preferably having 6 to 12 carbon atoms) may be bonded to a nitrogen atom.

It is preferable that the ammonium salt compound has an oxygen atom in the alkyl chain so as to form an oxyalkylene group. The number of the oxyalkylene groups is 1 or more, preferably 3 to 9, and more preferably 4 to 6 in a molecule. Among the oxyalkylene groups, an oxyethylene group ($-CH_2CH_2O-$) or an oxypropylene group ($-CH(CH_3)CH_2O-$ or $-CH_2CH_2CH_2O-$) is preferable, and an oxyethylene group is more preferable.

Examples of the anion of the ammonium salt compound include a halogen atom, sulfonate, borate, and phosphate, but among these, a halogen atom and sulfonate are preferable. As the halogen atom, chloride, bromide, and iodide are particularly preferable. As the sulfonate, an organic sulfonate having 1 to 20 carbon atoms is particularly preferable.

The amine compound having a phenoxy group can be obtained by heating a primary or secondary amine having a phenoxy group and haloalkyl ether so as to react with other, adding an aqueous solution of a strong base such as sodium hydroxide, potassium hydroxide, and tetraalkylammonium, and performing extraction with an organic solvent such as ethyl acetate and chloroform. Alternatively, the amine compound having a phenoxy group can be obtained by heating a primary or secondary amine and haloalkyl ether having a phenoxy group at a terminal so as to react with each other, adding an aqueous solution of a strong base such as sodium hydroxide, potassium hydroxide, and tetraalkylammonium, and performing extraction with an organic solvent such as ethyl acetate and chloroform.

As specific examples of the basic compound, those disclosed in paragraphs 0237 to 0294 of WO2015/178375A can be referred to, and the contents thereof are incorporated into the present specification. (Compound (PA) that generates a compound which has a proton acceptor functional group and is decomposed due to irradiation with actinic rays or radiation and in which proton acceptor properties decrease or disappear or proton acceptor properties change to acidity)

The actinic ray-sensitive or radiation-sensitive resin composition may further include a compound [hereinafter, also referred to as the compound (PA)] that generates a compound which has a proton acceptor functional group and is decomposed due to irradiation with actinic rays or radiation and in which proton acceptor properties decrease or disappear or proton acceptor properties change to acidity as the basic compound.

The proton acceptor functional group is a group that can electrostatically interacting with a proton or a functional group having an electron and means, for example, a functional group having a macrocyclic structure such as cyclic polyether or a functional group having a nitrogen atom having an unshared electron pair that does not contribute to $\pi$ conjugation. The nitrogen atom having an unshared electron pair that does not contribute to $\pi$ conjugation is, for example, a nitrogen atom having a partial structure represented by the following formula.

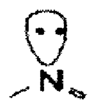
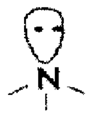
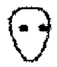

Unshared electron pair

Examples of preferable partial structures of the proton acceptor functional group include crown ether, azacrown ether, primary to tertiary amine, pyridine, imidazole, and pyrazine structures.

The compound (PA) is decomposed due to the irradiation with an actinic ray or radiation to generate a compound in which proton acceptor properties decrease or disappear or proton acceptor properties change to acidity. Here, the decrease or disappearance of the proton acceptor properties or the change from proton acceptor properties to acidity is a change in the proton acceptor properties due to the addition of a proton to the proton acceptor functional group, and specifically means that, in a case where a proton adduct is generated from the compound (PA) having a proton acceptor functional group and a proton, an equilibrium constant in the chemical equilibrium thereof decreases.

Specific examples of the compound (PA) include the following compounds. As specific examples of the compound (PA), for example, those disclosed in paragraphs 0421 to 0428 of JP2014-041328A and paragraphs 0108 to 0116 of JP2014-134686A can be referred to, and the content thereof is incorporated into the present specification.

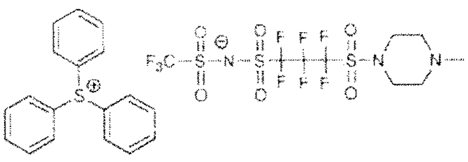
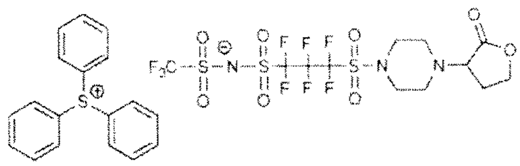

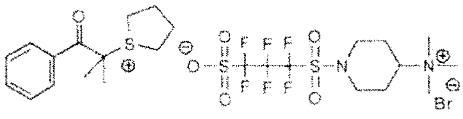
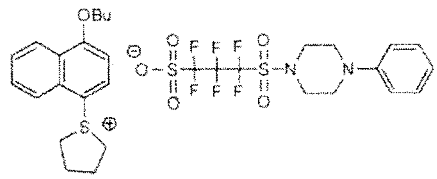

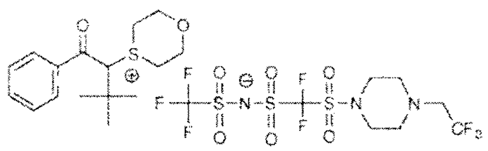
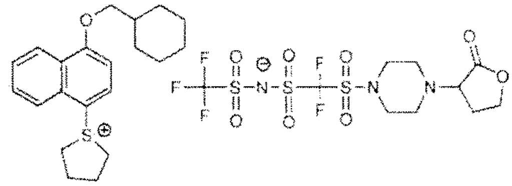

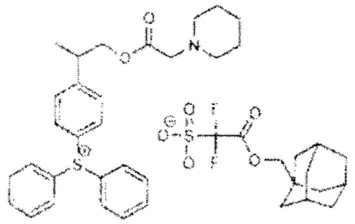
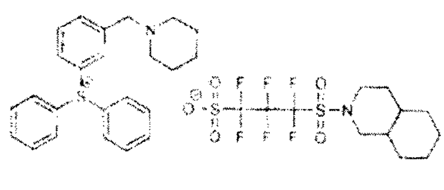

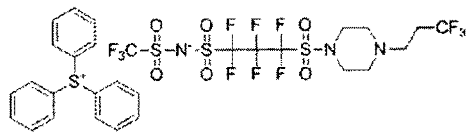
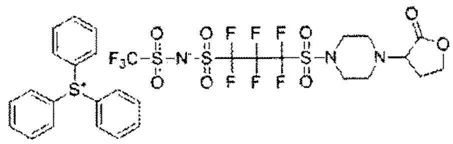

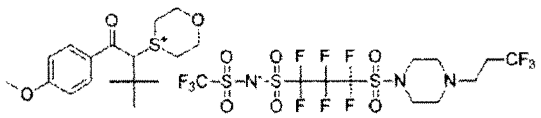
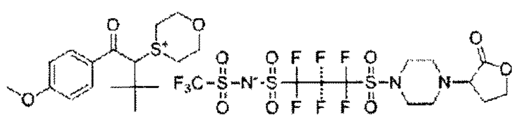

The basic compound is used singly or two or more kinds thereof are used in combination.

The use amount of the basic compound is generally 0.001 to 10 mass% and preferably 0.01 to 5 mass% based on the solid content of the actinic ray-sensitive or radiation-sensitive resin composition.

The use ratio of the acid generator and the basic compound in the composition preferably satisfies the acid generator / the basic compound (molar ratio) = 2.5 to 300. That is, in view of sensitivity and resolution, the molar ratio is preferably 2.5 or more, and is preferably 300 or less in view of suppression of resolution reduction due to thickening of the resist pattern in the elapse of time after exposure to heat treatment. The acid generator / basic compound (molar ratio) is more preferably 5.0 to 200 and even more preferably 7.0 to 150.

As the basic compound, for example, compounds (amine compound, amide group-containing compound, urea compound, and nitrogen-containing heterocyclic compound) disclosed in paragraphs 0140 to 0144 of JP2013-011833A can be used.

<Hydrophobic resin>

The actinic ray-sensitive or radiation-sensitive resin composition according to the embodiment of the present invention may further contain a hydrophobic resin different from the resin (A).

It is preferable that the hydrophobic resin is designed to be unevenly distributed on the surface of the resist film, but, differently from the surfactant, a hydrophilic group does not need to be included in the molecule and may not contribute to the even mixture of the polar/non-polar materials.

Examples of the effect of adding the hydrophobic resin include control a static/dynamic contact angle of a resist film surface against water, and the suppression of outgassing.

In view of the uneven distribution on the film surface, the hydrophobic resin preferably includes any one or more kinds of a "fluorine atom", a "silicon atom", or a "$CH_3$ partial structure contained in a side chain portion of the resin" and more preferably includes two or more kinds thereof. It is preferable that the hydrophobic resin contains a hydrocarbon group having 5 or more carbon atoms. These groups may be present in the main chain of the resin or may be substituted on the side chain.

In a case where the hydrophobic resin includes a fluorine atom and/or a silicon atom, the fluorine atom and/or the silicon atom in the hydrophobic resin may be included in the main chain of the resin and may be included in the side chain.

In the case where the hydrophobic resin includes a fluorine atom, the partial structure having a fluorine atom is preferably a resin having an alkyl group having a fluorine atom, a cycloalkyl group having a fluorine atom, or an aryl group having a fluorine atom.

The alkyl group (preferably having 1 to 10 carbon atoms and more preferably having 1 to 4 carbon atoms) having a fluorine atom is a linear or branched alkyl group in which at least one hydrogen atom is substituted with a fluorine atom and may further have a substituent other than the fluorine atom.

The cycloalkyl group having a fluorine atom is a monocyclic or polycyclic cycloalkyl group in which at least one hydrogen atom is substituted with a fluorine atom and may further have a substituent in addition to the fluorine atom.

Examples of the aryl group having a fluorine atom include an aryl group in which at least one hydrogen atom of an aryl group such as a phenyl group or a naphthyl group is substituted with a fluorine atom, and the aryl group may further have a substituent in addition to the fluorine atom.

Examples of the repeating units having a fluorine atom or a silicon atom include repeating units exemplified in paragraph 0519 of US2012/0251948A1.

As described above, it is also preferable that the hydrophobic resin includes a $CH_3$ partial structure in the side chain moiety.

Here, the $CH_3$ partial structure of the side chain moiety in the hydrophobic resin includes the $CH_3$ partial structure included in the ethyl group, the propyl group, or the like.

Meanwhile, a methyl group directly bonded to the main chain of the hydrophobic resin (for example, an $\alpha$-methyl group of a repeating unit having a methacrylic acid structure) is not included in the $CH_3$ partial structure in the present invention because contribution to uneven distribution on the surface of the hydrophobic resin is small due to the influence of the main chain.

With respect to the hydrophobic resin, the description of [0348] to [0415] of JP2014-010245A can be referred to, and the contents thereof are incorporated into the present specification.

As the hydrophobic resin, those disclosed in JP2011-248019A, JP2010-175859A, and JP2012-032544A can also be preferably used.

In a case where the actinic ray-sensitive or radiation-sensitive resin composition contains a hydrophobic resin, the content ratio of the hydrophobic resin is preferably 0.01 to 20 mass%, more preferably 0.01 to 10 mass%, even more preferably 0.05 to 8 mass%, and particularly preferably 0.5 to 5 mass% with respect to the total solid content of the actinic ray-sensitive or radiation-sensitive resin composition.

<Surfactant>

The actinic ray-sensitive or radiation-sensitive resin composition according to the embodiment of the present invention may further include a surfactant. In a case where the surfactant is contained, in a case where an exposure light source having a wavelength of 250 nm or lower, particularly 220 nm or lower is used, a pattern having excellent adhesiveness and fewer development defects can be formed at favorable sensitivity and resolutions.

As the surfactant, it is particularly preferable to use a fluorine-based and/or silicon-based surfactant.

Examples of the fluorine-based and/or silicon-based surfactants include surfactants disclosed in paragraph [0276] of US2008/0248425A. EFTOP EF301 or EF303 (manufactured by Mitsubishi Materials Electronic Chemicals Co., Ltd.); FLUORAD FC430, 431, or 4430 (manufactured by Sumitomo 3m Limited); MEGAFACE F171, F173, F176, F189, F113, F110, F177, F120, or R08 (manufactured by DIC Corporation); SURFLON S-382, SC101, 102, 103, 104, 105, or 106 (manufactured by Asahi Glass Co., Ltd.); TROYSOL S-366 (manufactured by Troy Corporation); GF-300 or GF-150 (manufactured by Toagosei Co., Ltd.), SURFLON S-393 (manufactured by AGC SEIMI CHEMICAL CO., LTD.), EFTOP EF121, EF122A, EF122B, RF122C, EF125M, EF135M, EF351, EF352, EF801, EF802, or EF601 (manufactured by Mitsubishi Materials Electronic Chemicals Co., Ltd.); PF636, PF656, PF6320, or PF6520 (manufactured by OMNOVA

Solutions Inc.); or FTX-204G, 208G, 218G, 230G, 204D, 208D, 212D, 218D, or 222D (manufactured by NEOS Company Limited). Polysiloxane polymer KP-341 (manufactured by Shin-Etsu Chemical Co., Ltd.) can also be used as the silicon-based surfactant.

In addition to the well-known surfactants as described above, the surfactant is synthesized with a fluoroaliphatic compound manufactured by a telomerization method (also referred to as a telomer method) or an oligomerization method (also referred to as an oligomer method). Specifically, a polymer comprising a fluoroaliphatic group derived from the fluoroaliphatic compound may be used as a surfactant. This fluoroaliphatic compound can be synthesized, for example, by the method described in JP2002-090991A.

The surfactants other than the fluorine-based and/or silicon-based surfactants disclosed in [0280] of US2008/0248425A may be used.

These surfactants may be used singly or two or more kinds thereof may be used in combination.

In a case where the actinic ray-sensitive or radiation-sensitive resin composition includes a surfactant, the content ratio thereof is preferably 0.0001 to 2 mass% and more preferably 0.0005 to 1 mass% with respect to the total solid content of the composition.

<Other additives>

The actinic ray-sensitive or radiation-sensitive resin composition according to the embodiment of the present invention may further include a dissolution inhibiting compound, a dye, a plasticizer, a photosensitizer, a light absorber, and/or a compound (for example, a phenol compound having a molecular weight of 1,000 or lower, alicyclic or aliphatic compound having a carboxy group) that promotes solubility in the developer.

The actinic ray-sensitive or radiation-sensitive resin composition may further include a dissolution inhibiting compound. Here, the "dissolution inhibiting compound" is a compound having a molecular weight of 3,000 or less, which is decomposed by the action of an acid so as to reduce solubility thereof in an organic developer.

The embodiment of the pattern forming method according to the embodiment of the present invention is described below.

[Pattern forming method]

The pattern forming method according to the embodiment of the present invention includes:

an actinic ray-sensitive or radiation-sensitive film forming step of forming an actinic ray-sensitive or radiation-sensitive film including an actinic ray-sensitive or radiation-sensitive resin composition according to the embodiment of the present invention;
an exposure step of exposing the actinic ray-sensitive or radiation-sensitive film; and
a development step of developing the exposed actinic ray-sensitive or radiation-sensitive film with a developer.

<Actinic ray-sensitive or radiation-sensitive film forming step>

A step of forming an actinic ray-sensitive or radiation-sensitive film is a step of forming the actinic ray-sensitive or radiation-sensitive film (typically, resist film) with the actinic ray-sensitive or radiation-sensitive resin composition, and, for example, the step can be performed by the following method.

In order to form an actinic ray-sensitive or radiation-sensitive film on a substrate with the actinic ray-sensitive or radiation-sensitive resin composition, the respective components are dissolved in a solvent, the actinic ray-sensitive or radiation-sensitive resin composition is prepared, filter filtration is performed, if necessary, and the substrate is coated. It is preferable that the filter is a filter made of polytetrafluoroethylene, polyethylene, or nylon which has a pore size of 0.1 μm or lower, more preferably 0.05 μm or lower, and even more preferably 0.03 μm or lower.

The actinic ray-sensitive or radiation-sensitive resin composition is applied by a suitable coating method such as spinner onto a substrate (for example, silicon and silicon dioxide coating) as used in the manufacture of integrated circuit elements. Thereafter, the actinic ray-sensitive or radiation-sensitive resin composition is dried so as to form the actinic ray-sensitive or radiation-sensitive film. If necessary, various underlying films (inorganic film, organic film, and antireflection film) may be formed on an underlayer the actinic ray-sensitive or radiation-sensitive film.

As the drying method, a method of heating and drying is generally used. The heating can be performed by means included in general exposing and developing machines and may be performed by using a hot plate or the like. The heating temperature is preferably 80°C to 150°C, more preferably 80°C to 140°C, and even more preferably 80°C to 130°C. The heating time is preferably 30 to 1,000 seconds, more preferably 60 to 800 seconds, and more preferably 60 to 600 seconds.

The film thickness of the actinic ray-sensitive or radiation-sensitive film is generally 200 nm or less and preferably

100 nm or less.

For example, in order to resolve a 1 : 1 line and space pattern having a line width of 20 nm or less, the film thickness of the formed actinic ray-sensitive or radiation-sensitive film is preferably 50 nm or less. In a case where the film thickness is 50 nm or less, pattern collapse is less likely to occur in a case where a development step described below is applied, and thus the more excellent resolution performance can be obtained.

The range of the film thickness is more preferably in the range of 15 nm to 45 nm. In a case where the film thickness is 15 nm or more, sufficient etching resistance can be obtained. The range of the film thickness is more preferably 15 nm to 40 nm. In a case where the film thickness is within this range, it is possible to simultaneously satisfy etching resistance and better resolution performance.

In the pattern forming method according to the embodiment of the present invention, an upper layer film (topcoat) may be formed on the upper layer of the actinic ray-sensitive or radiation-sensitive film. It is preferable that the topcoat is not mixed with the actinic ray-sensitive or radiation-sensitive film and can be evenly applied to an upper layer of the actinic ray-sensitive or radiation-sensitive film.

<Composition for forming upper layer film>

A composition (composition for forming topcoat) for forming an upper layer film is described below.

It is preferable that the topcoat is not mixed with the actinic ray-sensitive or radiation-sensitive film and evenly applied to the upper layer of the actinic ray-sensitive or radiation-sensitive film. The thickness of the topcoat is preferably 10 to 200 nm, more preferably 20 to 100 nm, and particularly preferably 40 to 80 nm.

The topcoat is not particularly limited, and a topcoat well-known in the related art can be formed by the well-known method in the related art. For example, the topcoat can be formed based on the disclosure of paragraphs <0072> to <0082> of JP2014-059543A.

<Exposure step>

The exposure step is a step of exposing the resist film and can be performed, for example, by the following method.

The actinic ray-sensitive or radiation-sensitive film formed as above is irradiated with an actinic ray or radiation through a predetermined mask. In electron beam irradiation, drawing (direct drawing) without a mask is common.

The actinic ray or radiation is not particularly limited, and examples thereof include a KrF excimer laser, an ArF excimer laser, an extreme ultraviolet ray (EUV), and an electron beam (EB), an extreme ultraviolet ray or an electron beam is particularly preferable. The exposure may be immersion exposure.

<Baking>

In the pattern forming method according to the embodiment of the present invention, it is preferable to perform baking (Post Exposure Bake: PEB) after the exposure and before the development is performed. The reaction of the exposed portion is promoted by baking, and sensitivity or a pattern shape becomes more satisfactory.

The heating temperature is preferably from 80°C to 150°C, more preferably 80°C to 140°C, and even more preferably from 80°C to 130°C.

The heating time is preferably 30 to 1,000 seconds, more preferably 60 to 800 seconds, and more preferably 60 to 600 seconds.

The heating can be performed by means included in general exposing and developing machines and may be performed by using a hot plate or the like.

<Development step>

A development step is a step of developing the exposed actinic ray-sensitive or radiation-sensitive film with a developer.

As the developing method, for example, a method of immersing a substrate in a tank filled with a developer for a predetermined period of time (dipping method), a developing method by raising the developer on the surface of a substrate by surface tension and leaving the developer to stand for a certain period of time (puddle method), a method of spraying a developer to the surface of a substrate (spraying method), and a method of continuously jetting a developer while scanning a developer jetting nozzle at a constant speed on a substrate spinning at a constant speed (dynamic dispensing method) can be applied.

After the step of developing, a step of stopping development may be carried out while substituting with another solvent.

The development time is not particularly limited as long as the resin in the exposed portion or the unexposed portion is sufficiently dissolved for the period of time, and the development time is usually 10 to 300 seconds and preferably 10 to 120 seconds.
The temperature of the developer is preferably 0°C to 50°C and more preferably 15°C to 35°C.

(Developer)

The developer may be an alkali developer and may be a developer (organic developer) that contains an organic solvent.

-Alkali developer-

As the alkaline developer, for example, an alkali aqueous solution of inorganic alkalis such as sodium hydroxide, potassium hydroxide, sodium carbonate, sodium silicate, sodium metasilicate, and ammonia water, primary amines such as ethylamine and n-propylamine, secondary amines such as diethylamine and di-n-butylamine, tertiary amines such as triethylamine and methyl diethylamine, alcohol amines such as dimethylethanolamine and triethanol amine, tetraalkyl ammonium hydroxide such as tetramethylammonium hydroxide, tetraethylammonium hydroxide, tetrapropylammonium hydroxide, tetrabutylammonium hydroxide, tetrapentylammonium hydroxide, tetrahexylammonium hydroxide, tetraoctylammonium hydroxide, ethyl trimethyl ammonium hydroxide, butyl trimethyl ammonium hydroxide, methyl triamyl ammonium hydroxide, and dibutyl dipentyl ammonium hydroxide, quaternary ammonium salt such as dimethylbis(2-hydroxyethyl) ammonium hydroxide, trimethylphenylammonium hydroxide, trimethylbenzylammonium hydroxide, and triethylbenzylammonium hydroxide, and cyclic amines such as pyrrole and piperidine can be used.
Alcohols and a surfactant may be added to the alkali aqueous solution in an appropriate amount for use.
The alkali concentration of the alkali developer is generally 0.1 to 20 mass%.
pH of the alkali developer is generally 10.0 to 15.0.
As the alkali developer, a 2.38 mass% aqueous solution of tetramethylammonium hydroxide is particularly desirable.

-Organic developer-

Next, the organic solvent included in the organic developer is described.
The vapor pressure of the organic solvent (vapor pressure as a whole in a case of a mixed solvent) at 20°C is preferably 5 kPa or less, more preferably 3 kPa or less, and particularly preferably 2 kPa or less. In a case where the vapor pressure of the organic solvent is 5 kPa or lower, the evaporation of the developer on the substrate or in a development cup is suppressed, and thus the temperature uniformity in the wafer surface increases, and as a result, the dimension uniformity in the wafer surface improves.
Various organic solvents are widely used as the organic solvent used in the organic developer, and for example, a solvent such as an ester-based solvent, a ketone-based solvent, an alcohol-based solvent, an amide-based solvent, an ether-based solvent, and a hydrocarbon-based solvent can be used.
Specific examples of these organic solvents are the same as those described above as the solvent (2) contained in the treatment liquid.
With respect to the organic solvent included in the organic developer, compared with a case where EUV light and EB is used in the exposure step, in view of suppressing the swelling of the actinic ray-sensitive or radiation-sensitive film, the number of carbon atoms is 7 or more (preferably 7 to 14, more preferably 7 to 12, and even more preferably 7 to 10), and it is preferable to use an ester-based solvent having 2 or less hetero atoms.
The hetero atom of the ester-based solvent is an atom in addition to the carbon atom and the hydrogen atom, and examples thereof include an oxygen atom, a nitrogen atom, and a sulfur atom. The number of hetero atoms is preferably 2 or less.
Preferable examples of the ester-based solvent having 7 or more carbon atoms and 2 or less hetero atoms include amyl acetate, isoamyl acetate, 2-methylbutyl acetate, 1-methylbutyl acetate, hexyl acetate, pentyl propionate, hexyl propionate, butyl propionate, isobutyl isobutyrate, heptyl propionate, and butyl butanoate, and it is particularly preferable to use isoamyl acetate.
With respect to the organic solvent included in the organic developer, in a case where EUV light and EB are used in the above exposure step, instead of an ester-based solvent having 7 or more carbon atoms and 2 or less hetero atoms, a mixed solvent of the ester-based solvent and the hydrocarbon solvent or a mixed solvent of the ketone-based solvent and the hydrocarbon solvent may be used. Also in this case, it is effective for suppressing the swelling of the actinic ray-sensitive or radiation-sensitive film.
In a case where an ester-based solvent and a hydrocarbon-based solvent are used in combination, it is preferable

to use isoamyl acetate as the ester-based solvent. As the hydrocarbon-based solvent, in view of adjusting the solubility of actinic ray-sensitive or radiation-sensitive film, it is preferable to use a saturated hydrocarbon solvent (for example, octane, nonane, decane, dodecane, undecane, or hexadecane).

In a case where a ketone-based solvent and a hydrocarbon-based solvent are used in combination, it is preferable to use 2-heptanone as a ketone-based solvent. As the hydrocarbon-based solvent, in view of adjusting the solubility of the actinic ray-sensitive or radiation-sensitive film, it is preferable to use a saturated hydrocarbon solvent (for example, octane, nonane, decane, dodecane, undecane, or hexadecane).

In the case of using the above mixed solvent, the content of the hydrocarbon-based solvent is not particularly limited, since the content depends on the solvent solubility of the actinic ray-sensitive or radiation-sensitive film, and the content of the hydrocarbon-based solvent is appropriately adjusted to determine the necessary amount.

The plurality of kinds of the organic solvents may be mixed or may be mixed with a solvent other than the above or water. In order to sufficiently obtain the effect of the present invention, the moisture content of the developer as a whole is preferably less than 10 mass%, and it is more preferable that substantially no moisture is contained. The concentration of the organic solvent (sum in the case of a plurality of organic solvents are mixed) in the developer is preferably 50 mass% or more, more preferably 50 to 100 mass%, even more preferably 85 to 100 mass%, still even more preferably 90 to 100 mass%, and particularly preferably 95 to 100 mass%. A case of substantially consisting only of an organic solvent is most preferable. The case of substantially consisting only of an organic solvent includes the case of containing a minute amount of a surfactant, an antioxidant, a stabilizer, and an antifoaming agent.

The developer preferably contains an antioxidant. As a result, the temporal generation of the oxidizing agent can be suppressed, and the content of the oxidizing agent can be further reduced. As the antioxidant, well-known antioxidants can be used, but in a case where an antioxidant is used for the semiconductor applications, an amine-based antioxidant and a phenol-based antioxidant are preferably used.

The content of the antioxidant is not particularly limited, but is preferably 0.0001 to 1 mass%, more preferably 0.0001 to 0.1 mass%, and still more preferably 0.0001 to 0.01 mass% with respect to the total mass of the developer. In a case where the content is 0.0001 mass% or more, a more excellent antioxidant effect can be obtained, and in a case where the content is 1 mass% or less, there is a tendency in that the development residues can be suppressed.

The developer may contain a basic compound, and specifically, examples thereof include a compound which is the same as the basic compound which may be contained in a resist composition.

The developer may contain a surfactant. In a case where the developer contains a surfactant, the wettability to the actinic ray-sensitive or radiation-sensitive film is improved, and the development more effectively proceeds.

As the surfactant, the same surfactant as the surfactant that can be contained in the resist composition can be used.

In a case where the developer contains a surfactant, the content of the surfactant is preferably 0.001 to 5 mass%, more preferably 0.005 to 2 mass%, and more preferably 0.01 to 0.5 mass% with respect to the total mass of the developer.

As the developing method, for example, a method of immersing a substrate in a tank filled with a developer for a predetermined period of time (dipping method), a developing method by raising the developer on the surface of a substrate by surface tension and leaving the developer to stand for a certain period of time (puddle method), a method of spraying a developer to the surface of a substrate (spraying method), and a method of continuously jetting a developer while scanning a developer jetting nozzle at a constant speed on a substrate spinning at a constant speed (dynamic dispensing method) can be applied.

After the development step, a step of stopping development may be performed while the solvent is substituted with another solvent.

The development time is not particularly limited, and is generally 10 to 300 seconds and preferably 20 to 120 seconds.

The temperature of the developer is preferably 0°C to 50°C and more preferably 15°C to 35°C.

As the developer used in the development step, both of the development using a developer containing an organic solvent and the development with an alkali developer may be performed (so-called double development may be performed).

In pattern forming method according to the embodiment of the present invention, the developer may include a treatment liquid of the present invention, and in this case, the treatment liquid is preferably a developer.

<Rinsing step>

The pattern forming method according to the embodiment of the present invention may include a rinsing step after a development step.

In the rinsing step, the wafer that has been developed is subjected to a washing treatment by using a rinsing solution.

The method of washing treatment is not particularly limited, and for example, a method of continuously jetting the rinsing solution to the substrate spinning at a constant speed (spin jetting method), a method of immersing a substrate in a tank filled with the rinsing solution for a predetermined period of time (dipping method), a method of spraying a rinsing solution to the surface of a substrate (spraying method), and the like can be applied. Among these, it is preferable that a washing treatment is performed by a spin jetting method, and after washing, the substrate is spun at the rotation speed of 2,000 rpm to 4,000 rpm, so as to remove the rinsing solution from the substrate.

The rinsing time is not particularly limited, but is preferably 10 seconds to 300 seconds, more preferably 10 seconds to 180 seconds, and most preferably 20 seconds to 120 seconds.

The temperature of the rinsing solution is preferably 0°C to 50°C and more preferably 15°C to 35°C.

After the developing treatment or the rinsing treatment, a treatment of removing the developer or the rinsing solution deposited to the pattern by a supercritical fluid can be performed.

After the developing treatment, a rinsing treatment, or a treatment by a supercritical fluid, a heat treatment can be performed in order to remove the solvent remaining in the pattern. The heating temperature is not particularly limited as long as a good resist pattern can be obtained, and is generally 40°C to 160°C. The heating temperature is preferably 50°C to 150°C and most preferably 50°C to 110°C. The heating time is not particularly limited as long as a good resist pattern can be obtained, but it is usually 15 to 300 seconds and preferably 15 to 180 seconds.

(Rinsing solution)

As the rinsing solution used in the rinsing treatment after the step of performing development with an alkali developer, pure water can be used, and an appropriate amount of a surfactant can be added to be used.

As the rinsing solution used in a rinsing treatment performed after the development step using an organic developer, it is preferable to use a rinsing solution including an organic solvent, and as the organic solvent, at least one organic solvent selected from the group consisting of a hydrocarbon-based solvent, a ketone-based solvent, an ester-based solvent an alcohol-based solvent, an amide-based solvent, and an ether-based solvent is preferable.

The organic solvent contained in the rinsing solution is preferably at least one selected from a hydrocarbon-based solvent, an ether-based solvent, or a ketone-based solvent and more preferably is at least one selected from a hydrocarbon-based solvent or an ether-based solvent.

As the organic solvent included in the rinsing solution, an ether-based solvent can also be appropriately used.

Specific examples of these organic solvents are the same as those described above for the organic solvent contained in the developer.

The vapor pressure of the rinsing solution at 20°C is preferably 0.05 kPa to 5 kPa, more preferably 0.1 kPa to 5 kPa, and most preferably 0.12 kPa to 3 kPa. In a case where the rinsing solution is a mixed solvent of a plurality of solvents, the vapor pressure as a whole is preferably within the above range. By setting the vapor pressure of the rinsing solution to 0.05 kPa to 5 kPa, temperature uniformity in the wafer surface is improved, swelling due to permeation of the rinsing solution is suppressed, dimensional uniformity in the wafer surface becomes satisfactory.

The organic solvent including the rinsing solution may be used singly or two or more kinds thereof may be used. In a case where two or more kinds thereof are included, examples thereof include a mixed solvent of undecane and diisobutyl ketone.

The rinsing solution may contain a surfactant. By causing the rinsing solution to contain the surfactant, there is a tendency in that the wettability to the resist film is improved, the rinse properties are improved, and the generation of foreign matter is suppressed.

As the surfactant, the same surfactant as used in the actinic ray-sensitive or radiation-sensitive resin composition described below can be used.

In a case where the rinsing solution contains a surfactant, the content of the surfactant is preferably 0.001 to 5 mass%, more preferably 0.005 to 2 mass%, and more preferably 0.01 to 0.5 mass% with respect to the total mass of the rinsing solution.

The rinsing solution may contain an antioxidant. The antioxidant that may be contained in the rinsing solution is the same as the antioxidant that may be contained in the developer.

In a case where the rinsing solution contains an antioxidant, the content of the antioxidant is not particularly limited, but is preferably 0.0001 to 1 mass%, more preferably 0.0001 to 0.1 mass%, and even more preferably 0.0001 to 0.01 mass% with respect to the total mass of the rinsing solution.

After the step of performing development with a developer including an organic solvent, a step of performing washing with a rinsing solution may be included, but in view of throughput (productivity), a step of performing washing with a rinsing solution may not be included.

As a treatment method not having a step of performing washing with a rinsing solution, for example, the description in [0014] to [0086] of JP2015-216403A can be referred to, and this content thereof is incorporated into the present specification.

As the rinsing solution, methyl isobutyl carbinol (MIBC) and a rinsing solution using the same liquid as the developer (particularly, butyl acetate) is also preferable.

<Storage container>

As the organic solvent (also referred to as an organic treatment liquid) that can be used in the treatment liquid such as a developer and a rinsing solution, it is preferable to use an organic solvent stored in a storage container of an organic treatment liquid for patterning a chemically amplified actinic ray-sensitive or radiation-sensitive film which has a storage portion. For example, this storage container is preferably a storage container of an organic treatment liquid for patterning the actinic ray-sensitive or radiation-sensitive film in which an inner wall of a storage portion which is in contact with the organic treatment liquid is formed of a resin different from any of a polyethylene resin, a polypropylene resin, and a polyethylene-polypropylene resin or metal subjected to an anti-corrosion/metal elution prevention treatment. An organic solvent to be used as an organic treatment liquid for patterning the actinic ray-sensitive or radiation-sensitive film is stored in the storage portion of the storage container, and in a case of patterning of the actinic ray-sensitive or radiation-sensitive film, a liquid discharged from the storage portion can be used.

In the case where the storage container further has a seal portion for tightly closing the storage portion, it is preferable that the seal portion is also formed of a resin different from the one or more resins selected from the group consisting of a polyethylene resin, a polypropylene resin, and a polyethylene-polypropylene resin or metal subjected to anti-corrosion/metal elution prevention treatments.

Here, the seal portion means a member that can shield the storage portion from the outside air, and suitable examples thereof include packing and an O ring.

The resin that is different from the one or more resins selected from the group consisting of a polyethylene resin, a polypropylene resin, and a polyethylene-polypropylene resin is preferably a perfluoro resin.

Examples of the perfluoro resin include a tetrafluoroethylene resin (PTFE), an ethylene tetrafluoride/perfluoroalkyl vinyl ether copolymer resin (PFA), an ethylene tetrafluoride-hexafluoropropylene copolymer resin (FEP), an ethylene tetrafluoride-ethylene copolymer resin (ETFE), a trifluorochloroethylene-ethylene copolymer resin (ECTFE), a vinylidene fluoride resin (PVDF), a trifluorochloroethylene copolymer resin (PCTFE), and a fluorinated vinyl resin (PVF).

Particularly preferable examples of the perfluoro resin include a tetrafluoroethylene resin, an ethylene tetrafluoride/perfluoroalkyl vinyl ether copolymer resin, and an ethylene tetrafluoride-hexafluoropropylene copolymer resin.

Examples of the metals in the metal subjected to anti-corrosion/metal elution prevention treatments include carbon steel, alloy steel, nickel-chrome steel, nickel-chrome-molybdenum steel, chrome steel, chrome-molybdenum steel, and manganese steel.

It is preferable to apply a coating technique, as the anti-corrosion/metal elution prevention treatments.

The coating technique is classified roughly into three parts: metal coating (various kinds of plating), inorganic coating (various chemical conversion treatments, glass, concrete, ceramics, and the like), and organic coating (anti-corrosion oil, paint, rubber, and plastics).

As a preferable coating technique, surface treatments with anti-corrosion oil, a rust preventing agent, a corrosion inhibitor, a chelate compound, strippable plastic, and a lining agent are used.

Among them, a corrosion inhibitor such as various chromic acid salts, a nitric acid salt, a silicic acid salt, phosphoric acid salt, carboxylic acids such as oleic acid, dimer acid, and naphthenic acid, carboxylic acid metal soap, a sulfonic acid salt, an amine salt, and esters (glycerin ester and phosphoric acid ester of higher fatty acid), a chelate compound such as ethylenediamine tetraacetic acid, gluconic acid, nitrilotriacetic acid, hydroxyethyl ethylenediamine triacetic acid, and diethylenetriamine pentaacetic acid, and a fluororesin lining is preferable. A phosphoric acid salt treatment and fluororesin lining are particularly preferable.

Compared with a direct coating treatment, though corrosion is not directly prevented, it is preferable that the "pre-treatment" which is a step before the anti-corrosion treatment is performed is employed as a treatment method for extending the anti-corrosion period by a coating treatment.

As a specific example of the pre-treatment, treatments for removing various corrosion factors such as chloride or sulfate which exist on metal surfaces by washing or polishing are preferably used.

Specific examples of the storage container include the followings.

- FluoroPurePFA composite drum manufactured by Entegris Inc. (liquid contact inner surface; PFA resin lining)
- Steel drum manufactured by JFE CONTAINER Co., Ltd. (liquid contact inner surface; zinc phosphate film)

Examples of the storage container that can be used in the present invention include containers disclosed in [0013] to [0030] of JP1999-021393A (JP-H11-021393A) and [0012] to [0024] of JP1998-045961A (JP-H10-045961A).

A conductive compound may be added to the organic treatment liquid in order to prevent chemical liquid piping and various parts (such as filters, o-rings, or tubes) due to subsequently occurring static electricity discharge which from

being broken. The conductive compound is not particularly limited, but examples thereof include methanol. The addition amount is not particularly limited, and in view of maintaining preferable development characteristics, the addition amount is preferably 10 mass% or less and more preferably 5 mass% or less. With respect to the members of the chemical liquid piping, it is possible to use stainless steel (SUS) or various kinds of piping coated with polyethylene, polypropylene, and a fluororesin (such as polytetrafluoroethylene and perfluoroalkoxy resins) which are subjected to an antistatic treatment. In the same manner, polyethylene, polypropylene, and a fluororesin (such as polytetrafluoroethylene and perfluoroalkoxy resins) subjected to an antistatic treatment can also be used for filters and O-rings.

Generally, the developer and the rinsing solution are stored in a waste liquid tank through piping after use. In this case, in a case where a hydrocarbon-based solvent is used as the rinsing solution, in order to prevent the resist dissolved in the developer from precipitating and adhering to a rear surface of a wafer, a side surface of piping, or the like, a method of causing a solvent in which the resist dissolves to pass through piping may be used. Examples of the method of passing through the piping include a method of washing a rear surface of a side surface of a substrate after washing with a rinsing solution with a solvent which dissolves a resist and flowing the rinsing solution or a method of flowing a solvent which dissolves a resist through the piping without causing the solvent to come into contact with the resist.

The solvent that passes through the piping is not particularly limited, as long as the solvent can dissolve the resist, examples thereof include the organic solvents described above, and propylene glycol monomethyl ether acetate (PGMEA), propylene glycol monoethyl ether acetate, propylene glycol monopropyl ether acetate, propylene glycol monobutyl ether acetate, propylene glycol monomethyl ether propionate, propylene glycol monoethyl ether propionate, ethylene glycol monomethyl ether acetate, ethylene glycol monoethyl ether acetate, propylene glycol monomethyl ether (PGME), propylene glycol monoethyl ether, propylene glycol monopropyl ether, propylene glycol monobutyl ether, ethylene glycol monomethyl ether, ethylene glycol monoethyl ether, 2-heptanone, ethyl lactate, 1-propanol, and acetone can be used. Among these, preferably, PGMEA, PGME, and cyclohexanone can be used.

A semiconductor fine circuit, an imprint mold structure, a photo mask, and the like can be manufactured by using the pattern that can be obtained by the pattern forming method according to the embodiment of the present invention as a mask and appropriately performing an etching treatment, ion implantation, and the like.

The pattern formed by the method can be used in the guide pattern formation (for example, see ACS Nano Vol. 4, No. 8, Pages 4815 to 4823) in Directed Self-Assembly (DSA). The pattern formed, for example, by the above method can be used as a core of a spacer process disclosed in JP1991-270227A(JP-H03-270227A) and JP2013-164509A.

A process in a case where an imprint mold is formed by the pattern forming method according to the embodiment of the present invention is disclosed, for example, in JP4109085B, JP2008-162101A, and "Nanoimprint fundamentals and technology development • application development - substrate technology of nanoimprint and the latest technology development - edited by: Yoshihiko Hirai (Frontier Publishing)".

A photo mask manufactured by using the pattern forming method according to the embodiment of the present invention may be a light transmission type mask used in ArF excimer laser and the like or may be a light reflection type mask used in reflection type lithography in which EUV light is used as a light source.

The present invention also relates to a method of manufacturing an electronic device including the pattern forming method according to the embodiment of the present invention.

The electronic device manufactured by the method of manufacturing the electronic device according to the embodiment of the present invention can be appropriately mounted on electric or electronic apparatuses (household electric devices, office appliance (OA) media-related apparatuses, optical apparatuses, and telecommunication apparatuses). Examples

Hereinafter, the present invention will be described in more detail with reference to examples, but the present invention is not limited thereto.

<Synthesis of resin (A)>

Synthesis Example 1: Synthesis of resin (A-19)

4.9 g of a monomer (1), 6.7 g of a monomer (2), 9.1 g of a monomer (3), and 0.50 g of a polymerization initiator V-601 (manufactured by Wako Pure Chemical Industries, Ltd.) were dissolved in 76.1 g of cyclohexanone. 41.0 g of cyclohexanone was placed in a reaction vessel and added dropwise to a system at 85°C in a nitrogen gas atmosphere over four hours. The reaction solution was heated and stirred for two hours and then allowed to cool to room temperature. The reaction solution was added dropwise to 1377 g of a mixed solution of n-heptane and ethyl acetate (n-heptane / ethyl acetate = 9/1 (mass ratio)) to precipitate the polymer, and filtration was performed. The filtered solid was washed with 413 g of a mixed solution of n-heptane and ethyl acetate (n-heptane / ethyl acetate = 9 / 1 (mass ratio)). Thereafter, the washed solid was dried under reduced pressure so as to obtain 12.4 g of a resin (A-19). The weight-average molecular weight by GPC was 14,300, and the molecular weight dispersion degree (Mw / Mn) was 1.48. $^{1}$H-NMR (DMSO-d6: ppm)

δ: 8.75-8.39, 6.83-5.95, 4.59-3.66, 3.61-2.88, 2.64-0.18 (all peaks were broad)

[A-19]

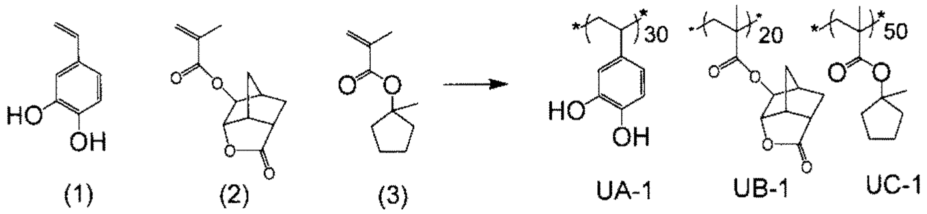

(1) (2) (3) UA-1 UB-1 UC-1

Mw=14300
Mw/Mn=1.48

The weight-average molecular weight (Mw: in terms of polystyrene), the number-average molecular weight (Mn: in terms of polystyrene), and a dispersion degree (Mw / Mn) of the obtained resin (A-19) were calculated by the measurement of GPC (carrier: tetrahydrofuran (THF)). In the GPC, TSK gel Multipore HXL-M (manufactured by Tosoh Corporation, 7.8 mm ID × 30.0 cm) was used as a column by using HLC-8120 (manufactured by Tosoh Corporation). In addition, the compositional ratio (molar ratio) was calculated by $^{1}$H-NMR (Nuclear Magnetic Resonance) and $^{13}$C-NMR measurement.

The same operation as in Synthesis Example 1 was performed so as to synthesize the resins A-1 to A-33 presented in the following table as the resin (A).

[Table 1]

| Resin | Unit number | mol% | Unit number | mol% | Unit number | mol% | Weight-average molecular weight (Mw) | Dispersion degree (Mw / Mn) |
|---|---|---|---|---|---|---|---|---|
| A-1 | UA-1 | 30 | UB-2 | 25 | UC-1 | 45 | 14300 | 1.48 |
| A-2 | UA-2 | 30 | UB-2 | 25 | UC-1 | 45 | 16600 | 1.51 |
| A-3 | UA-3 | 30 | UB-2 | 25 | UC-1 | 45 | 12500 | 1.45 |
| A-4 | UA-4 | 30 | UB-2 | 25 | UC-1 | 45 | 13800 | 1.34 |
| A-5 | UA-5 | 30 | UB-2 | 25 | UC-1 | 45 | 15500 | 1.35 |
| A-6 | UA-6 | 30 | UB-2 | 25 | UC-1 | 45 | 14100 | 1.42 |
| A-7 | UA-7 | 30 | UB-2 | 25 | UC-1 | 45 | 13700 | 1.55 |
| A-8 | UA-8 | 30 | UB-2 | 25 | UC-1 | 45 | 15900 | 1.31 |
| A-9 | UA-1 | 5 | UB-3 | 40 | UC-5 | 55 | 14300 | 1.48 |
| A-10 | UA-1 | 20 | UB-3 | 25 | UC-5 | 55 | 13800 | 1.60 |
| A-11 | UA-1 | 30 | UB-3 | 15 | UC-5 | 55 | 14500 | 1.48 |
| A-12 | UA-1 | 45 | UB-3 | 5 | UC-5 | 50 | 16600 | 1.55 |
| A-13 | UA-1 | 65 | UB-3 | 5 | UC-5 | 30 | 13700 | 1.45 |
| A-14 | UA-6 | 30 | UB-3 | 15 | UC-1 | 55 | 12700 | 1.55 |
| A-15 | UA-6 | 30 | UB-3 | 15 | UC-2 | 55 | 13300 | 1.38 |
| A-16 | UA-6 | 30 | UB-3 | 15 | UC-3 | 55 | 17000 | 1.57 |
| A-17 | UA-6 | 30 | UB-3 | 15 | UC-4 | 55 | 14500 | 1.56 |
| A-18 | UA-6 | 30 | UB-3 | 15 | UC-5 | 55 | 13700 | 1.45 |
| A-19 | UA-1 | 30 | UB-1 | 20 | UC-1 | 50 | 14300 | 1.48 |
| A-20 | UA-9 | 30 | UB-1 | 20 | UC-1 | 50 | 16600 | 1.44 |
| A-21 | UA-10 | 30 | UB-1 | 20 | UC-1 | 50 | 16600 | 1.44 |
| A-22 | UA-11 | 30 | UB-1 | 20 | UC-1 | 50 | 16600 | 1.44 |
| A-23 | UA-2 | 35 | UB-2 | 10 | UC-3 | 55 | 12600 | 1.60 |
| A-24 | UA-2 | 35 | UB-2 | 10 | UC-6 | 55 | 14400 | 1.44 |
| A-25 | UA-2 | 35 | UB-2 | 10 | UC-8 | 55 | 14500 | 1.56 |
| A-26 | UA-2 | 35 | UB-2 | 10 | UC-9 | 55 | 14100 | 1.55 |
| A-27 | UA-2 | 35 | UB-2 | 10 | UC-10 | 55 | 13300 | 1.41 |
| A-28 | UA-2 | 35 | UB-2 | 10 | UC-11 | 55 | 14300 | 1.48 |
| A-29 | UA-2 | 35 | UB-2 | 10 | UC-12 | 55 | 13800 | 1.60 |
| A-30 | UA-2 | 35 | UB-2 | 10 | UC-7 | 55 | 14000 | 1.55 |
| A-31 | UA-2 | 35 | UB-2 | 10 | UC-13 | 55 | 14500 | 1.50 |
| A-32 | UA-2 | 35 | UB-2 | 10 | UC-14 | 55 | 14400 | 1.44 |
| A-33 | UA-2 | 40 | UC-6 | 10 | UC-2 | 50 | 16000 | 1.50 |

Repeating units specified by the unit number presented in Table 1 are as follows.

[Unit having phenolic hydroxyl group]

UA-1
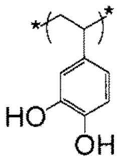
UA-2
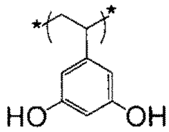
UA-3
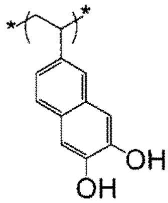
UA-4
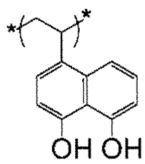
UA-5
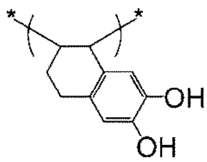

UA-6
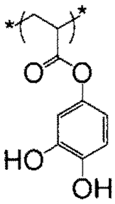
UA-7
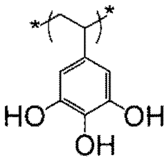
UA-8
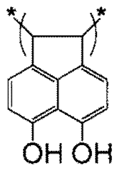
UA-9
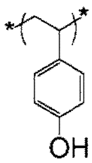
UA-10
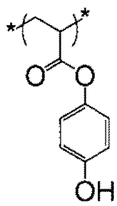
UA-11
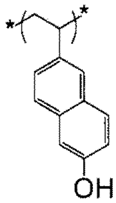

[Lactone structure-containing unit and alicyclic structure-containing unit having polar group]

UB-1
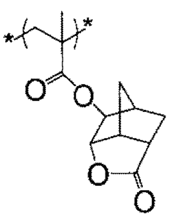
UB-2
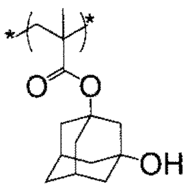
UB-3
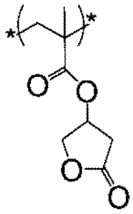

[Acid-decomposable unit]

UC-1
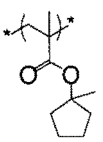
UC-2
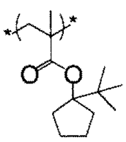
UC-3
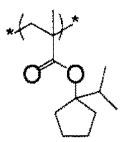
UC-4
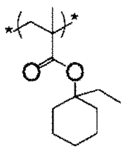
UC-5
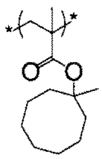
UC-6
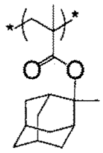

UC-7
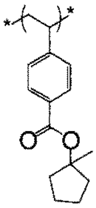
UC-8
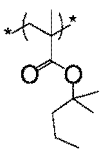
UC-9
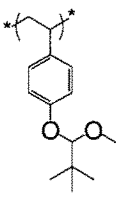
UC-10
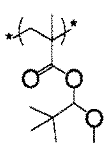
UC-11
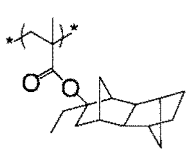
UC-12
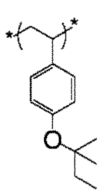

UC-13

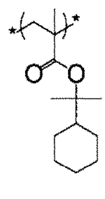

UC-14

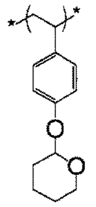

As the component other than the resin used in the preparation of the resist composition, a photoacid generator, a basic compound, a surfactant, a hydrophobic resin, and a solvent are provided below.

[Photoacid generator]

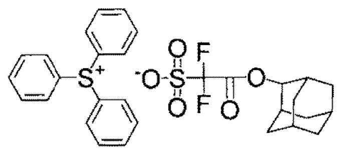

P-1

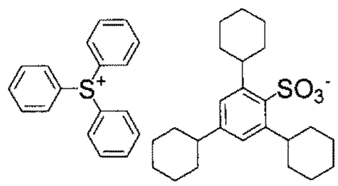

P-2

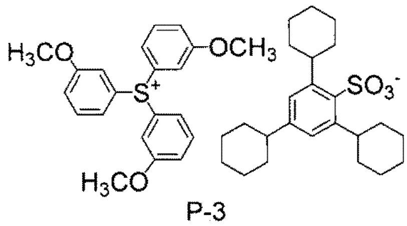

P-3

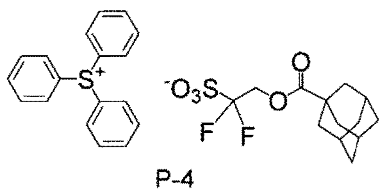

P-4

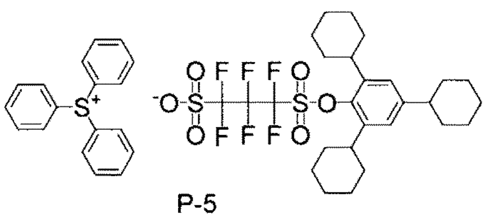

P-5

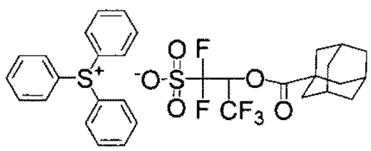

P-6

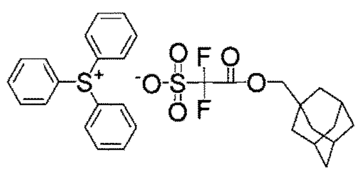

P-7

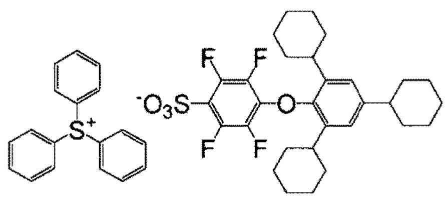

P-8

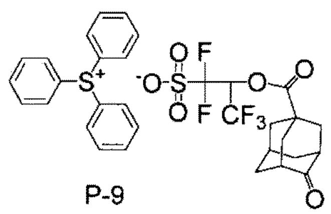

P-9

[Basic compound]

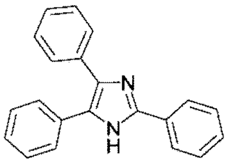

C-1

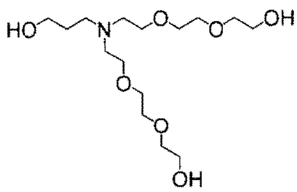

C-2

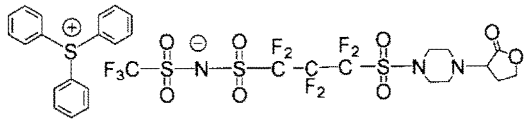

C-3

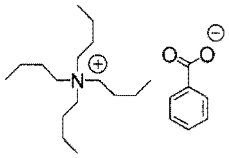

C-4

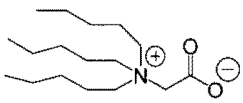

C-5

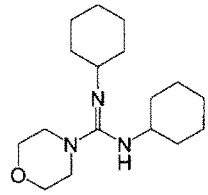

C-6

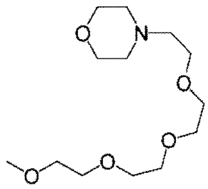

C-7

[Surfactant]

W-1: MEGAFACE F176 (manufactured by DIC Corporation) (fluorine-based)
W-2: MEGAFACE R08 (manufactured by DIC Corporation) (fluorine and silicon-based)
W-3: Polysiloxane polymer KP-341 (manufactured by Shin-Etsu Chemical Co., Ltd.) (silicon-based)
W-4: Troysol S-366 (manufactured by Troy Corporation)
W-5: KH-20 (manufactured by Asahi Kasei Corporation)
W-6: PolyFox (Registered trademark) PF-6320 (manufactured by OMNOVA solution Inc.) (fluorine-based)

[Hydrophobic resin]

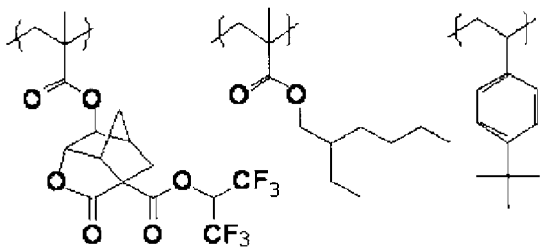

TP-1 MW 8,000 Mw/Mn = 1.4 Molar ratio (from the left) 90/2/8

[Resist solvent]

SL-1: Propylene glycol monomethyl ether acetate (PGMEA)
SL-2: Propylene glycol monomethyl ether propionate
SL-3: 2-Heptanone
SL-4: Ethyl lactate
SL-5: Propylene glycol monomethyl ether (PGME)
SL-6: Cyclohexanone

<Preparation of resist composition>

The components presented in Table 2 were dissolved in a solvent at the composition presented in the same table, and each was filtered through a polyethylene filter having a pore size of 0.03 μm so to obtain a resist composition.

[Table 2-1]

| | Resist composition | Resin (A) | | Acid generator (B) | | Basic compound | | Surfactant | | Hydrophobic resin | | Resist solvent | |
|---|---|---|---|---|---|---|---|---|---|---|---|---|---|
| | | Compound Number | Parts by mass | Compound Number | Parts by mass | Compound Number | Parts by mass | Compound Number | Parts by mass | Compound Number | Parts by mass | Compound Number | Parts by mass |
| Example 1 | 1 | A-1 | 41 | P-4 | 7 | C-1 | 2 | | | | | SL-1/SL-5 | 2200/250 |
| Example 2 | 2 | A-2 | 41 | P-4 | 7 | C-1 | 2 | | | | | SL-1/SL-5 | 2200/250 |
| Example 3 | 3 | A-3 | 41 | P-4 | 7 | C-1 | 2 | | | | | SL-1/SL-5 | 2200/250 |
| Example 4 | 4 | A-4 | 41 | P-4 | 7 | C-1 | 2 | | | | | SL-1/SL-5 | 2200/250 |
| Example 5 | 5 | A-5 | 41 | P-4 | 7 | C-1 | 2 | | | | | SL-1/SL-5 | 2200/250 |
| Example 6 | 6 | A-6 | 41 | P-4 | 7 | C-1 | 2 | | | | | SL-1/SL-5 | 2200/250 |
| Example 7 | 7 | A-7 | 41 | P-4 | 7 | C-1 | 2 | | | | | SL-1/SL-5 | 2200/250 |
| Example 8 | 8 | A-8 | 41 | P-4 | 7 | C-1 | 2 | | | | | SL-1/SL-5 | 2200/250 |
| Example 9 | 9 | A-9 | 39 | P-1 | 8 | C-1 | 2 | W-1 | 1 | | | SL-1/SL-5 | 2200/250 |
| Example 10 | 10 | A-10 | 39 | P-1 | 8 | C-1 | 2 | W-1 | 1 | | | SL-1/SL-5 | 2200/250 |
| Example 11 | 11 | A-11 | 39 | P-1 | 8 | C-1 | 2 | W-1 | 1 | | | SL-1/SL-5 | 2200/250 |
| Example 12 | 12 | A-12 | 39 | P-1 | 8 | C-1 | 2 | W-1 | 1 | | | SL-1/SL-5 | 2200/250 |
| Example 13 | 13 | A-13 | 39 | P-1 | 8 | C-1 | 2 | W-1 | 1 | | | SL-1/SL-5 | 2200/250 |
| Example 14 | 14 | A-14 | 40 | P-4 | 9 | C-1 | 1 | | | | | SL-1/SL-5 | 2200/250 |
| Example 15 | 15 | A-15 | 40 | P-4 | 9 | C-1 | 1 | | | | | SL-1/SL-5 | 2200/250 |
| Example 16 | 16 | A-16 | 40 | P-4 | 9 | C-1 | 1 | | | | | SL-1/SL-5 | 2200/250 |
| Example 17 | 17 | A-17 | 40 | P-4 | 9 | C-1 | 1 | | | | | SL-1/SL-5 | 2200/250 |
| Example 18 | 18 | A-18 | 40 | P-4 | 9 | C-1 | 1 | | | | | SL-1/SL-5 | 2200/250 |
| Example 19 | 19 | A-19 | 42 | P-4 | 7 | C-1 | 1 | | | | | SL-1/SL-5 | 2200/250 |
| Example 20 | 20 | A-23 | 39 | P-4 | 10 | C-1 | 1 | | | | | SL-1/SL-5 | 2200/250 |

[Table 2-2]

| | Resist composition | Resin (A) | | Acid generator (B) | | Basic compound | | Surfactant | | Hydrophobic resin | | Resist solvent | |
|---|---|---|---|---|---|---|---|---|---|---|---|---|---|
| | | Compound Number | Parts by mass | Compound Number | Parts by mass | Compound Number | Parts by mass | Compound Number | Parts by mass | Compound Number | Parts by mass | Compound Number | Parts by mass |
| Example 21 | 21 | A-19 | 40 | P-1 | 9 | C-2 | 1 | | | | | SL-1/SL-5 | 2200/250 |
| Example 22 | 22 | A-19 | 40 | P-2 | 9 | C-3 | 1 | | | | | SL-1/SL-5 | 2200/250 |
| Example 23 | 23 | A-19 | 38 | P-3 | 9 | C-4 | 2 | W-6 | 1 | | | SL-1/SL-5 | 2200/250 |
| Example 24 | 24 | A-19 | 40 | P-3/P-4 | 4/5 | C-5 | 1 | | | | | SL-1/SL-5 | 2200/250 |
| Example 25 | 25 | A-19 | 39 | P-5 | 9 | C-6 | 1 | | | TP-1 | 1 | SL-1/SL-5 | 2200/250 |
| Example 26 | 26 | A-1/A-19 | 20/20 | P-6 | 8 | C-7 | 2 | | | | | SL-1/SL-5 | 2200/250 |
| Example 27 | 27 | A-19 | 38 | P-7 | 9 | C-1/C-2 | 1/1 | W-1 | 1 | | | SL-1/SL-5 | 2200/250 |
| Example 28 | 28 | A-19 | 37 | P-8 | 9 | C-1/C-3 | 1/1 | W-2/W-4 | 1/1 | | | SL-1/SL-5 | 2200/250 |
| Example 29 | 29 | A-19 | 39 | P-9 | 9 | C-1/C-4 | 1/1 | | | | | SL-1/SL-5 | 2200/250 |
| Example 30 | 30 | A-30 | 39 | P-2 | 10 | C-1 | 1 | | | | | SL-1/SL-5 | 2200/250 |
| Example 31 | 31 | A-31 | 39 | P-2 | 10 | C-1 | 1 | | | | | SL-1/SL-5 | 2200/250 |
| Example 32 | 32 | A-32 | 39 | P-4 | 10 | C-1 | 1 | | | | | SL-1/SL-5 | 2200/250 |
| Example 33 | 33 | A-33 | 39 | P-4 | 10 | C-1 | 1 | | | | | SL-1/SL-5 | 2200/250 |
| Comparative Example 1 | c1 | A-20 | 37 | P-4 | 10 | C-1 | 2 | W-4 | 1 | | | SL-1/SL-5 | 2200/250 |
| Comparative Example 2 | c2 | A-21 | 37 | P-4 | 9 | C-1 | 2 | W-5 | 2 | | | SL-1/SL-5 | 2200/250 |
| Comparative Example 3 | c3 | A-22 | 37 | P-4 | 9 | C-1 | 2 | W-5 | 2 | | | SL-1/SL-5 | 2200/250 |
| Comparative Example 4 | c4 | A-24 | 42 | P-4 | 7 | C-1 | 1 | | | | | SL-1/SL-5 | 2200/250 |
| Comparative Example 5 | c5 | A-25 | 39 | P-4 | 9 | C-1 | 2 | | | | | SL-1/SL-5 | 2200/250 |
| Comparative Example 6 | c6 | A-26 | 39 | P-4 | 8 | C-1 | 2 | W-3 | 1 | | | SL-1/SL-2 | 2200/250 |

(continued)

| | Resist composition | Resin (A) | | Acid generator (B) | | Basic compound | | Surfactant | | Hydrophobic resin | | Resist solvent | |
|---|---|---|---|---|---|---|---|---|---|---|---|---|---|
| | | Compound Number | Parts by mass | Compound Number | Parts by mass | Compound Number | Parts by mass | Compound Number | Parts by mass | Compound Number | Parts by mass | Compound Number | Parts by mass |
| Comparative Example 7 | c7 | A-27 | 42 | P-4 | 7 | C-1 | 1 | | | | | SL-1/SL-3 | 2200/250 |
| Comparative Example 8 | c8 | A-28 | 39 | P-4 | 9 | C-1 | 2 | | | | | SL-1/SL-4 | 2200/250 |
| Comparative Example 9 | c9 | A-29 | 36 | P-4 | 10 | C-1 | 2 | W-4 | 2 | | | SL-1/SL-6 | 2200/250 |

<Formation of line and space pattern / EUV exposure>

A silicon wafer was coated with an organic antireflection film ARC29SR (manufactured by Brewer Science, Inc.) and baked at 205°C for 60 seconds, so as to form an antireflection film having a film thickness of 86 nm, coating with the resist composition presented in Table 2 was performed thereon, and baking was performed at 120°C for 60 seconds so as to form a resist film having a film thickness of 40 nm.

An EUV exposure device (Micro Exposure Tool manufactured by Exitech Corporation, NA 0.3, Quadrupole, outer sigma 0.68, inner sigma 0.36) was used, and an exposure mask (mask having line / space = 1/1) was used, so as to perform pattern exposure. After the pattern exposure was performed, baking (PEB) was performed on a hot plate at 120°C for 60 seconds, the developer presented in Table 3 was puddled, development was performed for 30 seconds, and rinsing was performed with a rinsing solution presented in the same table. Subsequently, the wafer was spun at a rotation speed of 2,000 rpm for 30 seconds, and then a 1 : 1 line and space pattern with a line width of 18 nm to 30 nm was obtained.

[Evaluation of resist pattern/EUV exposure]

Performance evaluation of the resist pattern was performed with a scanning electron microscope (S-9380 II manufactured by Hitachi, Ltd.).

<Resolution>

Critical resolution (minimum line width in which separating and resolving are performed without collapse) at the optimum exposure amount (Eopt) in the obtained 1 : 1 line and space pattern with a line width of 16 nm to 30 nm was set as the resolution (nm). As the value is smaller, the resolution is excellent and satisfactory.

<Line width roughness (LWR)>

With respect to the line width roughness, the line width was measured for any 50 points in the longitudinal direction of 0.5 $\mu$m in the line and space pattern (line : space = 1 : 1) with a line width of 24 nm in the Eopt, the standard deviation thereof was calculated, so as to calculate 3 $\sigma$ (nm). As the value is smaller, the performance is better.

<EL performance>

With respect to EL, the line width of a line and space pattern with a pitch of 48 nm was measured and was calculated by the following expression. As the value is greater, the performance is better.

EL = {Sensitivity at which line width become 26.4 nm (line width that satisfies 1 : 1 + 10%) - sensitivity at which line width become 21.6 nm (line width that satisfies 1 : 1 - 10%)} / sensitivity at which line width become 24 nm (line width that satisfies 1 : 1) × 100 (%)

<Outgassing performance>

Evaluation was performed with respect to a fluctuation (Z) in the film thickness in a case where a coating film with a film thickness of 60 nm was irradiated with the irradiation energy in a case where 1 : 1 line and space pattern with a line width of 20 nm was resolved.

Z = [(Film thickness before exposure) - (Film thickness after exposure)]

Here, the film thickness after the exposure refers to a film thickness of the coating film immediately after the exposure, and is a film thickness of a resist film before the heating (PEB) step after the exposure. The smaller value of Z means that the generation of the outgassing becomes less and outgassing performance is excellent.

Resist treatment liquids (developer and rinsing solution) presented in Table 3 are provided below.

[Resist treatment liquid]

DR-1: Butyl acetate
DR-2: 3-Methylbutyl acetate
DR-3: 2-Heptanone
DR-4: 2.38 mass% tetramethylammonium hydroxide aqueous solution
DR-5: Undecane
DR-6: Diisobutyl ketone
DR-7: Mixed liquid of undecane / diisobutyl ketone = 30 / 70 (mass ratio)
DR-8: Decane
DR-9: Mixed liquid of decane / diisobutyl ketone = 15 / 85 (mass ratio)
DR-10: Diisoamyl ether
DR-11: Mixed liquid of diisoamyl ether / diisobutyl ketone = 20 / 80 (mass ratio)
DR-12: Mixed liquid of 3-methylbutyl acetate / diisobutyl ketone = 30 / 70 (mass ratio)
DR-13: Pure water

[Table 3]

| | Resist composition | Developer | Rinsing solution | Resolution (nm) | EL (%) | LWR (nm) | Outgassing (nm) |
|---|---|---|---|---|---|---|---|
| Example 101 | 1 | DR-1 | None | 19 | 27 | 3.5 | 2.8 |
| Example 102 | 2 | DR-1 | None | 19 | 29 | 4 | 3 |
| Example 103 | 3 | DR-1 | None | 19 | 25 | 4 | 3.7 |
| Example 104 | 4 | DR-1 | None | 19 | 24 | 4.4 | 3.7 |
| Example 105 | 5 | DR-1 | None | 19 | 25 | 4.3 | 3.5 |
| Example 106 | 6 | DR-1 | None | 20 | 23 | 4.5 | 3.6 |
| Example 107 | 7 | DR-1 | None | 20 | 24 | 4.4 | 3.9 |
| Example 108 | 8 | DR-1 | None | 20 | 23 | 4 | 3.5 |
| Example 109 | 9 | DR-1 | None | 20 | 23 | 4.7 | 4.5 |
| Example 110 | 10 | DR-1 | None | 18 | 29 | 3.2 | 3.4 |
| Example 111 | 11 | DR-1 | None | 18 | 28 | 3.4 | 3.1 |
| Example 112 | 12 | DR-1 | None | 20 | 20 | 4.5 | 4.5 |
| Example 113 | 13 | DR-1 | None | 20 | 19 | 5 | 4.6 |
| Example 114 | 14 | DR-1 | None | 17 | 28 | 3 | 2.9 |
| Example 115 | 15 | DR-1 | None | 18 | 29 | 3.1 | 3.1 |
| Example 116 | 16 | DR-1 | None | 18 | 29 | 3.2 | 3.5 |
| Example 117 | 17 | DR-1 | None | 21 | 20 | 4.7 | 4.1 |
| Example 118 | 18 | DR-1 | None | 20 | 20 | 4.6 | 4.7 |
| Example 119 | 19 | DR-1 | None | 18 | 26 | 3 | 3.1 |
| Example 120 | 20 | DR-1 | None | 17 | 29 | 3.6 | 3.1 |
| Example 121 | 21 | DR-1 | None | 19 | 30 | 3.4 | 2.9 |
| Example 122 | 22 | DR-1 | None | 19 | 27 | 4 | 2.9 |
| Example 123 | 23 | DR-1 | None | 18 | 28 | 3 | 3 |
| Example 124 | 24 | DR-1 | None | 19 | 26 | 3.2 | 2.6 |

(continued)

| | Resist composition | Developer | Rinsing solution | Resolution (nm) | EL (%) | LWR (nm) | Outgassing (nm) |
|---|---|---|---|---|---|---|---|
| Example 125 | 25 | DR-1 | None | 18 | 26 | 3.7 | 2.7 |
| Example 126 | 26 | DR-1 | None | 18 | 30 | 3.6 | 3.5 |
| Example 127 | 27 | DR-1 | None | 17 | 30 | 3.1 | 3 |
| Example 128 | 28 | DR-1 | None | 19 | 25 | 3.2 | 3.5 |
| Example 129 | 29 | DR-1 | None | 18 | 29 | 3.9 | 3.1 |
| Example 130 | 30 | DR-1 | None | 21 | 18 | 4.9 | 5 |
| Example 131 | 31 | DR-1 | None | 21 | 18 | 4.8 | 4.5 |
| Example 132 | 32 | DR-1 | None | 20 | 20 | 4.7 | 3.5 |
| Example 133 | 33 | DR-1 | None | 17 | 30 | 3.5 | 2.7 |
| Example 134 | 19 | DR-1 | DR-5 | 19 | 29 | 3.3 | 2.5 |
| Example 135 | 19 | DR-1 | DR-7 | 17 | 25 | 3.9 | 3.3 |
| Example 136 | 19 | DR-1 | DR-8 | 19 | 29 | 3.5 | 2.8 |
| Example 137 | 19 | DR-1 | DR-9 | 18 | 26 | 3.6 | 2.6 |
| Example 138 | 19 | DR-2 | DR-10 | 17 | 26 | 3.8 | 3.4 |
| Example 139 | 19 | DR-3 | DR-11 | 17 | 27 | 4 | 2.8 |
| Example 140 | 19 | DR-4 | DR-13 | 20 | 25 | 4.3 | 4 |
| Example 141 | 19 | DR-6 | DR-12 | 17 | 25 | 3.6 | 3.5 |
| Comparative Example 101 | c1 | DR-1 | None | 22 | 18 | 5.5 | 5.5 |
| Comparative Example 102 | c2 | DR-1 | None | 23 | 15 | 5.9 | 5.3 |
| Comparative Example 103 | c3 | DR-1 | None | 24 | 16 | 5.1 | 5.9 |
| Comparative Example 104 | c4 | DR-1 | None | 22 | 17 | 5.8 | 5.4 |
| Comparative Example 105 | c5 | DR-1 | None | 24 | 17 | 5.2 | 5.7 |
| Comparative Example 106 | c6 | DR-1 | None | 23 | 18 | 5.1 | 5.2 |
| Comparative Example 107 | c7 | DR-1 | None | 22 | 17 | 5.1 | 5.1 |
| Comparative Example 108 | c8 | DR-1 | None | 22 | 15 | 6 | 5 |
| Comparative Example 109 | c9 | DR-1 | None | 24 | 16 | 5.5 | 5.9 |

<Evaluation in case of using an electron beam (EB) irradiation device>

A pattern was formed by the same method as described above, except that an electron beam irradiation device (JBX 6000 manufactured by JEOL Corporation, accelerating voltage 50 keV) was used instead of the EUV exposure device, and the exposure was performed by changing an irradiation amount such that a line pattern (length direction 0.2 mm, drawing number 40 lines) with a line width of 18 nm to 25 nm in increments of 2.5 nm was formed. With respect to

the obtained pattern, the same evaluation as described above was performed. As a result, it was confirmed that excellent resolution, LWR, EL, and outgassing performance were able to be achieved even in a case where an electron beam (EB) irradiation device was used.

## Claims

1. An actinic ray-sensitive or radiation-sensitive resin composition comprising:

a resin including a repeating unit (a) represented by Formula (I-1) and a repeating unit (b) having a group in which a protective group including an aliphatic monocyclic ring leaves due to an action of an acid to generate a polar group; and
a compound that generates an acid due to irradiation with an actinic ray or radiation,

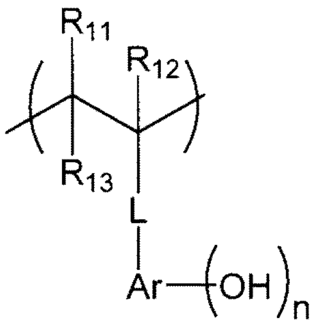

(I-1)

in the formula,

$R_{11}$ and $R_{12}$ each independently represent a hydrogen atom or an alkyl group,
$R_{13}$ represents a hydrogen atom or an alkyl group, or is a single bond or an alkylene group, and is bonded to L or Ar in the formula to form a ring,
L represents a single bond or a divalent linking group,
Ar represents an aromatic ring, and
n represents an integer of 2 or more.

2. The actinic ray-sensitive or radiation-sensitive resin composition according to claim 1, wherein, in the repeating unit (b), the polar group generated by leaving of the protective group is a carboxyl group.

3. The actinic ray-sensitive or radiation-sensitive resin composition according to claim 1 or 2, wherein, in the repeating unit (b), the aliphatic monocyclic ring included in the protective group is a monocyclic hydrocarbon group.

4. The actinic ray-sensitive or radiation-sensitive resin composition according to any one of claims 1 to 3, wherein, in Formula (I-1), Ar is a benzene ring, and n is an integer of 2 to 5.

5. The actinic ray-sensitive or radiation-sensitive resin composition according to any one of claims 1 to 4, wherein, in Formula (I-1), n is 2 or 3.

6. The actinic ray-sensitive or radiation-sensitive resin composition according to any one of claims 1 to 5, wherein, in Formula (I-1), L is a single bond or an ester bond.

7. The actinic ray-sensitive or radiation-sensitive resin composition according to any one of claims 1 to 6, wherein a content of the repeating unit (a) represented by Formula (I-1) is 5 to 60 mol% with respect to all repeating units in the resin.

8. The actinic ray-sensitive or radiation-sensitive resin composition according to any one of claims 1 to 7, wherein the repeating unit (b) is represented by Formula (pA),

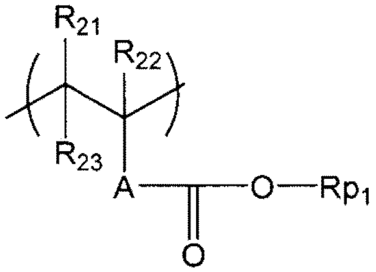

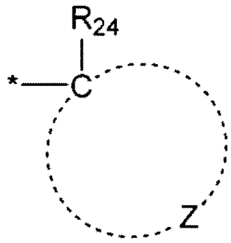

(pA) (pI)

in Formula (pA),

$R_{21}$, $R_{22}$, and $R_{23}$ each independently represent a hydrogen atom or an alkyl group,
A represents a single bond or a divalent linking group, and
$Rp_1$ represents a group represented by Formula (pI), and
in Formula (pI),
$R_{24}$ represents a methyl group, an ethyl group, an n-propyl group, an isopropyl group, an n-butyl group, an isobutyl group, a sec-butyl group, or a tert-butyl group,
Z represents an atomic group required for forming a monocyclic cycloalkyl group together with a carbon atom in the formula, and
* represents a linking portion to a remainder of a repeating unit represented by Formula (pA).

**9.** The actinic ray-sensitive or radiation-sensitive resin composition according to claim 8, wherein, in Formula (pA), A is a single bond.

**10.** The actinic ray-sensitive or radiation-sensitive resin composition according to claim 8 or 9, wherein, in Formula (pA), the number of carbon atoms of the cycloalkyl group formed by Z together with carbon atoms in the formula is 5 to 10.

**11.** A pattern forming method, comprising:

forming an actinic ray-sensitive or radiation-sensitive film including the actinic ray-sensitive or radiation-sensitive resin composition according to any one of claims 1 to 10;
exposing the actinic ray-sensitive or radiation-sensitive film; and
developing the exposed actinic ray-sensitive or radiation-sensitive film with a developer.

**12.** The pattern forming method according to claim 11, wherein the developer contains an organic solvent.

**13.** A method of manufacturing an electronic device comprising:
the pattern forming method according to claim 11 or 12.

**Patentansprüche**

**1.** Gegenüber aktinischer Strahlung empfindliche oder strahlungsempfindliche Harzzusammensetzung, umfassend:

ein Harz, umfassend eine durch die Formel (I-1) dargestellte Wiederholungseinheit (a) und eine Wiederholungseinheit (b) mit einer Gruppe, worin eine Schutzgruppe, die einen aliphatischen monocyclischen Ring umfasst, aufgrund der Einwirkung einer Säure unter Erzeugung einer polaren Gruppe austritt; und
eine Verbindung, die durch Bestrahlung mit aktinischer Strahlung oder Strahlung eine Säure erzeugt,

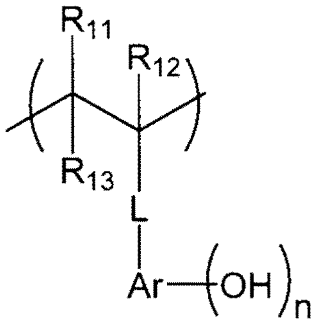

(I-1)

worin in der Formel

$R_{11}$ und $R_{12}$ jeweils unabhängig voneinander ein Wasserstoffatom oder eine Alkylgruppe darstellen,
$R_{13}$ ein Wasserstoffatom oder eine Alkylgruppe darstellt, oder eine Einfachbindung oder eine Alkylengruppe ist, und in der Formel an L oder Ar gebunden ist, um einen Ring zu bilden,
L eine Einfachbindung oder eine divalente Verknüpfungsgruppe darstellt,
Ar einen aromatischen Ring darstellt, und
n eine ganze Zahl von 2 oder mehr darstellt.

2. Gegenüber aktinischer Strahlung empfindliche oder strahlungsempfindliche Harzzusammensetzung gemäß Anspruch 1, worin die in der Wiederholungseinheit (b) durch Austritt der Schutzgruppe erzeugte polare Gruppe eine Carboxylgruppe ist.

3. Gegenüber aktinischer Strahlung empfindliche oder strahlungsempfindliche Harzzusammensetzung gemäß Anspruch 1 oder 2, worin in der Wiederholungseinheit (b) der in der Schutzgruppe umfasste aliphatische monocyclische Ring eine monocyclische Kohlenwasserstoffgruppe ist.

4. Gegenüber aktinischer Strahlung empfindliche oder strahlungsempfindliche Harzzusammensetzung gemäß irgendeinem der Ansprüche 1 bis 3, worin in der Formel (I-1) Ar ein Benzolring ist und n eine ganze Zahl von 2 bis 5 ist.

5. Gegenüber aktinischer Strahlung empfindliche oder strahlungsempfindliche Harzzusammensetzung gemäß irgendeinem der Ansprüche 1 bis 4, wobei in der Formel (I-1) n 2 oder 3 ist.

6. Gegenüber aktinischer Strahlung empfindliche oder strahlungsempfindliche Harzzusammensetzung gemäß irgendeinem der Ansprüche 1 bis 5, wobei in der Formel (I-1) L eine Einfachbindung oder eine Esterbindung ist.

7. Gegenüber aktinischer Strahlung empfindliche oder strahlungsempfindliche Harzzusammensetzung gemäß irgendeinem der Ansprüche 1 bis 6, wobei der Gehalt der durch die Formel (I-1) dargestellten Wiederholungseinheit (a) 5 bis 60 Mol-% beträgt, bezogen auf alle Wiederholungseinheiten im Harz.

8. Gegenüber aktinischer Strahlung empfindliche oder strahlungsempfindliche Harzzusammensetzung gemäß irgendeinem der Ansprüche 1 bis 7, worin die Wiederholungseinheit (b) durch die Formel (pA) dargestellt wird

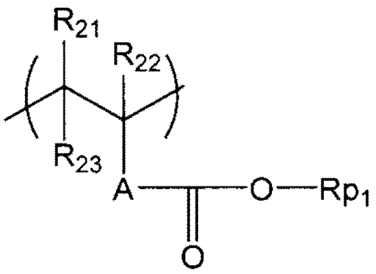

(pA)

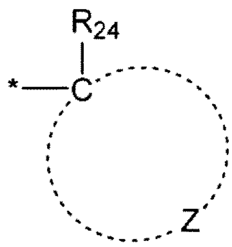

(pI)

worin in Formel (pA),

$R_{21}$, $R_{22}$, und $R_{23}$ jeweils unabhängig voneinander ein Wasserstoffatom oder eine Alkylgruppe darstellen,
A eine Einfachbindung oder eine divalente Verknüfungsgruppe darstellt und
$Rp_1$ eine durch die Formel (pI) dargestellte Gruppe darstellt, und
in Formel (pI),
$R_{24}$ eine Methylgruppe, eine Ethylgruppe, eine n-Propylgruppe, eine Isopropylgruppe, eine n-Butylgruppe, eine Isobutylgruppe, eine sec-Butylgruppe oder eine tert-Butylgruppe darstellt,
Z eine Atomgruppe darstellt, die zur Bildung einer monocyclischen Cycloalkylgruppe zusammen mit einem Kohlenstoffatom in der Formel erforderlich ist, und
* einen Verbindungsabschnitt zu einem Rest einer durch die Formel (pA) dargestellten Wiederholungseinheit darstellt.

9. Gegenüber aktinischer Strahlung empfindliche oder strahlungsempfindliche Harzzusammensetzung gemäß Anspruch 8, worin A in Formel (pA) eine Einfachbindung ist.

10. Gegenüber aktinischer Strahlung empfindliche oder strahlungsempfindliche Harzzusammensetzung nach Anspruch 8 oder 9, wobei in Formel (pA) die Anzahl der Kohlenstoffatome der Cycloalkylgruppe, die durch Z zusammen mit Kohlenstoffatomen in der Formel gebildet wird, 5 bis 10 beträgt.

11. Verfahren zur Bildung einer Struktur, umfassend:

Bilden eines gegenüber aktinischer Strahlung empfindlichen oder strahlungsempfindlichen Films, der die gegenüber aktinischer Strahlung empfindliche oder strahlungsempfindliche Harzzusammensetzung gemäß irgendeinem der Ansprüche 1 bis 10 umfasst;
Belichten des gegenüber aktinischer Strahlung empfindlichen oder strahlungsempfindlichen Films; und
Entwickeln des gegenüber aktinischer Strahlung empfindlichen oder strahlungsempfindlichen Films mit einem Entwickler.

12. Verfahren zur Bildung einer Struktur gemäß Anspruch 11, wobei der Entwickler ein organisches Lösungsmittel enthält.

13. Verfahren zur Herstellung einer elektronischen Vorrichtung, umfassend
das Verfahren zur Bildung einer Struktur gemäß Anspruch 11 oder 12.

## Revendications

1. Composition de résine sensible aux rayons ou sensible au rayonnement actinique(s) comprenant :

une résine incluant une unité de répétition (a) représentée par la formule (I-1) et une unité de répétition (b) présentant un groupe dans lequel un groupe protecteur incluant un cycle monocyclique aliphatique disparaît en raison d'une action d'un acide pour générer un groupe polaire ; et
un composé qui génère un acide en raison d'une irradiation avec un rayon ou rayonnement actinique,

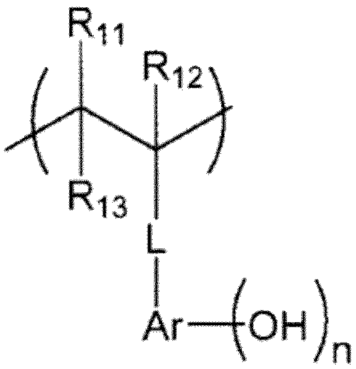

(I-1)

dans la formule,

$R_{11}$ et $R_{12}$ représentent chacun indépendamment un atome d'hydrogène ou un groupe alkyle,
$R_{13}$ représente un atome d'hydrogène ou un groupe alkyle, ou est une liaison simple ou un groupe alkylène, et est lié à L ou Ar dans la formule pour former un cycle,
L représente une liaison simple ou un groupe de liaison divalent,
Ar représente un cycle aromatique, et
n représente un nombre entier de 2 ou plus.

**2.** Composition de résine sensible aux rayons ou sensible au rayonnement actinique(s) selon la revendication 1, dans laquelle, dans l'unité de répétition (b), le groupe polaire généré par la disparition du groupe protecteur est un groupe carboxyle.

**3.** Composition de résine sensible aux rayons ou sensible au rayonnement actinique(s) selon la revendication 1 ou 2, dans laquelle, dans l'unité de répétition (b), le cycle monocyclique aliphatique inclus dans le groupe protecteur est un groupe hydrocarboné monocyclique.

**4.** Composition de résine sensible aux rayons ou sensible au rayonnement actinique(s) selon l'une quelconque des revendications 1 à 3, dans laquelle, dans la formule (I-1), Ar est un cycle benzène, et n est un nombre entier de 2 à 5.

**5.** Composition de résine sensible aux rayons ou sensible au rayonnement actinique(s) selon l'une quelconque des revendications 1 à 4, dans laquelle, dans la formule (I-1), n est 2 ou 3.

**6.** Composition de résine sensible aux rayons ou sensible au rayonnement actinique(s) selon l'une quelconque des revendications 1 à 5, dans laquelle, dans la formule (I-1), L est une liaison simple ou une liaison ester.

**7.** Composition de résine sensible aux rayons ou sensible au rayonnement actinique(s) selon l'une quelconque des revendications 1 à 6, dans laquelle une teneur en unité de répétition (a) représentée par la formule (I-1) est de 5 à 60 % en moles par rapport à toutes les unités de répétition dans la résine.

**8.** Composition de résine sensible aux rayons ou sensible au rayonnement actinique(s) selon l'une quelconque des revendications 1 à 7, dans laquelle l'unité de répétition (b) est représentée par la formule (pA),

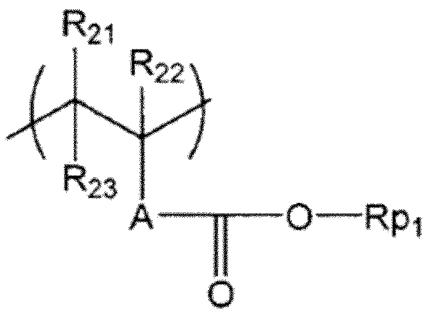

(pA)

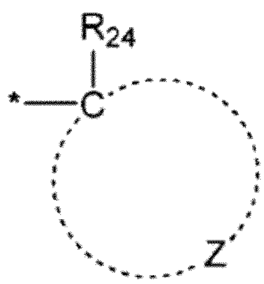

(pI)

dans la formule (pA),

$R_{21}$, $R_{22}$, et $R_{23}$ représentent chacun indépendamment un atome d'hydrogène ou un groupe alkyle,
A représente une liaison simple ou un groupe de liaison divalent, et
$Rp_1$ représente un groupe représenté par la formule (pI), et
dans la formule (pI),
$R_{24}$ représente un groupe méthyle, un groupe éthyle, un groupe n-propyle, un groupe isopropyle, un groupe n-butyle, un groupe isobutyle, un groupe sec-butyle, ou un groupe ter-butyle,
Z représente un groupe atomique exigé pour former un groupe cycloalkyle monocyclique conjointement avec un atome de carbone dans la formule, et
* représente une partie de liaison à un reste d'une unité de répétition représentée par la formule (pA).

**9.** Composition de résine sensible aux rayons ou sensible au rayonnement actinique(s) selon la revendication 8, dans laquelle, dans la formule (pA), A est une liaison simple.

**10.** Composition de résine sensible aux rayons ou sensible au rayonnement actinique(s) selon la revendication 8 ou 9, dans laquelle, dans la formule (pA), le nombre d'atomes de carbone du groupe cycloalkyle formé par Z conjointement avec des atomes de carbone dans la formule est de 5 à 10.

**11.** Procédé de formation de motif, comprenant :

une formation d'un film sensible aux rayons ou sensible au rayonnement actinique(s) incluant la composition de résine sensible aux rayons ou sensible au rayonnement actinique(s) selon l'une quelconque des revendications 1 à 10 ;
une exposition du film sensible aux rayons ou sensible au rayonnement actinique(s) ; et
un développement du film sensible aux rayons ou sensible au rayonnement actinique(s) exposé avec un développateur.

**12.** Procédé de formation de motif selon la revendication 11, dans lequel le développateur contient un solvant organique.

**13.** Procédé de fabrication d'un dispositif électronique comprenant :
le procédé de formation de motif selon la revendication 11 ou 12.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 8337616 A
- JP H08337616 A
- JP 2000267280 A
- JP 2005275282 A
- US 2015147699 A1
- JP 2009086354 A
- JP 2015197482 A
- EP 0996870 A1
- JP 2012219162 A
- JP 2014041326 A
- CN 101974121 A
- JP 2014232309 A
- JP 2014041327 A
- JP 2014041328 A
- US 20150004533 A
- JP 2013228681 A
- WO 2015178375 A
- JP 2014134686 A
- JP 2013011833 A
- US 20120251948 A1
- JP 2014010245 A
- JP 2011248019 A
- JP 2010175859 A
- JP 2012032544 A
- US 20080248425 A
- JP 2002090991 A
- JP 2014059543 A
- JP 2015216403 A
- JP 11021393 A
- JP H11021393 A
- JP 10045961 A
- JP H10045961 A
- JP 3270227 A
- JP H03270227 A
- JP 2013164509 A
- JP 4109085 B
- JP 2008162101 A


### Non-patent literature cited in the description


- *ACS Nano,* vol. 4 (8), 4815-4823
- Nanoimprint fundamentals and technology development • application development - substrate technology of nanoimprint and the latest technology development. Frontier Publishing